**Europäisches Patentamt**

**European Patent Office**

**Office européen des brevets**

(19)

(11) Veröffentlichungsnummer : **0 312 498 B1**

(12)

# EUROPÄISCHE PATENTSCHRIFT

(45) Veröffentlichungstag der Patentschrift :
**12.08.92 Patentblatt 92/33**

(51) Int. Cl.$^5$ : **H05K 13/00**

(21) Anmeldenummer : **88810693.7**

(22) Anmeldetag : **07.10.88**

(54) **Transportverfahren für Platten.**

(30) Priorität : **13.10.87 CH 3995/87**

(43) Veröffentlichungstag der Anmeldung :
**19.04.89 Patentblatt 89/16**

(45) Bekanntmachung des Hinweises auf die
Patenterteilung :
**12.08.92 Patentblatt 92/33**

(84) Benannte Vertragsstaaten :
**AT BE CH DE FR GB IT LI NL SE**

(56) Entgegenhaltungen :
**EP-A- 0 224 440**
**DE-A- 2 525 496**
**DE-U- 8 327 161**
**FR-A- 2 439 734**

(73) Patentinhaber : **CIBA-GEIGY AG**
**Klybeckstrasse 141**
**CH-4002 Basel (CH)**

(72) Erfinder : **Wenger, Hartmut**
**St. Jakobstrasse 81**
**CH-4133 Pratteln (CH)**
Erfinder : **Martin, Peter**
**Gerbergässlein 18**
**CH-4051 Basel (CH)**
Erfinder : **Rotzinger, Hans**
**Ziegelhofweg 7**
**CH-4303 Kaiseraugst (CH)**
Erfinder : **Denz, Martin**
**Waldenburgerstrasse 10**
**CH-4052 Basel (CH)**

EP 0 312 498 B1

## Beschreibung

Die Erfindung betrifft ein Transportverfahren für Platten oder plattenförmige Werkstücke gemäss Oberbegriff des Patentanspruches 1.

Es sind unterschiedliche Vorrichtungen für den Transport von Platten bekannt, die berücksichtigen sollen, daß die Oberflächen der Platten geschont werden. Dies ist vor allem dann notwendig, wenn naßbeschichtete Leiterplatten von den Beschichtungs- in die Trocknungsstationen befördert werden sollen. Solche Leiterplatten werden nämlich mit einem Schutzlack beschichtet, der zunächst getrocknet, dann belichtet und an den belichteten Stellen herausentwickelt wird, Dadurch können dann an diesen vorgewählten Stellen die Leiterbahnen mit elektrischen Kontakten versehen werden. Vor dem Beschichten müssen solche Platten gereinigt, vorgewärmt, danach beschichtet, anschließend abgelüftet und schließlich getrocknet werden. Dabei besteht ein weiteres Problem darin, daß in der Regel beide Oberflächen der Platte beschichtet und entsprechend behandelt werden müssen, wobei während der Beschichtung der zweiten Oberfläche die auf der ersten Ober.flache befindliche Schicht noch nicht ausgehärtet ist, also verletzungsempfindlich ist.

Aus der DE-A-25 25 496 ist eine Anlage zum Fördern plattenförmiger, allerdings flexibler Materialien wie Druckereierzeugnisse, z.B. Zeitungen, Zeitschriften und dergleichen bekannt, bei welcher quer zur Vorschuboder Förderrichtung liegende Träger mit an ihren Enden angeordneten federbelasteten Greifvorrichtungen zu einer endlosen Förderstrecke an einer umlaufenden Förderkette verbunden sind und die Greifvorrichtungen den Randbereich des Druckereierzeugnisses umgreifen, während ein Mittelbereich unterstützt wird. Dies wäre für den Transport von frisch beschichteten Platten nicht brauchbar, weil nicht nur ein sehr großer Randbereich von den Greifern erfaßt wird, so daß schon dort die Beschichtung beeinträchtigt werden könnte, sondern weil die Unterstützungsvorrichtung die noch nicht ausgehärtete Beschichtung der einen Plattenseite beschädigen könnte. Darüber hinaus ist eine solche Vorrichtung nur für eine bestimmte Förderstrecke geeignet, während der Übergang von einem Förderelement zu einem anderen, beispielsweise beim Übergang von einer Bearbeitungsstation zur anderen schwierig ist und ein Erfassen der Platten an weiteren Stellen erfordert, die von den Greifern der ersten Fördervorrichtung nicht beaufschlagt sind.

FR-A-2 439 734 offenbart ein Transportverfahren gemäß dem Oberbegriff der Patentanspruches 1.

Aus der FR-A-2 439 734 ist eine Transportvorrichtung für Leiterplatten mit gedruckten Schaltungen bekannt, die einen Endlosförderer mit Kettenantrieb hat, wobei die Platten im Bereich des Obertrums dieses Förderelementes in nach oben offenen Schlitzen stecken, so daß ihre Oberflächen etwa vertikal orientiert sind. Dabei wird also jeweils nur ein Plattenlängsrand umfaßt. Ein solches Förderelement wäre jedoch ungeeignet für frisch beschichtete Platten, weil dann die Flüssigkeit an der Plattenoberfläche zumindest teilweise ablaufen würde und entsprechende Spuren und Tränen bilden könnte. Darüber hinaus muß an den Übergabestellen zu und von diesem Förderer wiederum Vorsorge für eine entsprechende Relativbewegung zwischen Förderelement und Platte getroffen werden, um die Platte aus dem Förderelement zu einer weiteren Arbeitsstation bringen zu können, so daß wiederum zusätzliche Greifer od.dgl. an den Platten angreifen müssen.

Aus der EP-A-0,224,440 ist zum Transport von Platten eine Vorrichtung mit zwei parallel laufenden Fördermitteln bekannt, welche zueinandergerichtete V-förmig profilierte Halterungen aufweist. Diese Halterungen fassen die horizontal liegenden Platten an ihren Rändern und transportieren sie durch die Bearbeitungsstation. Insbesondere an den Be- und Entladestationen, beim Uebergang von einer Bearbeitungsstation zur nächsten, fehlen nach dem bekannten Stand der Technik-entsprechende schonende Uebernahmevorrichtungen für die Platten.

Eine Uebernahmevorrichtung ist beispielsweise aus der DE-U-83 27 161.9 bekannt. Beim Transport mit dieser Vorrichtung wird die Platte von zwei Greifern an ihren Rändern gefasst. Mehrere Abstandshalter sind notwendig, um ein seitliches Verkippen der Platten zu verhindern, Diese seitlichen Abstandshalter führen vielfach bei frisch beschichteten Platten zu Beschädigungen der Beschichtung. Ausserdem kann diese Vorrichtung nur für kleine Platten einer bestimmten Mindeststärke eingesetzt werden. Leiterplatten üblicher Stärke (0,8 mm) und Grösse biegen sich durch und entgleiten so den Greifern.

Weitere Schwierigkeiten beim Transport von Platten mit vorbekannten Vorrichtungen treten auf, wenn Platten unterschiedlicher Abmessungen nacheinander auf ihnen transportiert werden müssen.

Es besteht deshalb die Aufgabe, ein Transportverfahren für Platten mit einer Vorrichtung zu schaffen, die ein schonendes Erfassen und Transportieren der Platten erlaubt , wobei auch der Übergang von einer Bearbeitungsstation zur nächsten einfach und ohne zusätzliche Beanspruchung der Plattenränder erfolgen können soll. Dabei soll das Verfahren es auch ermöglichen, die Platten erforderlichenfalls in unterschiedlichen Richtungen übergeben zu können und dabei auch einen Wechsel des Vorschubes aus einer horizontalen in eine auf- und/oder abwärtsgerichtete Fördervorrichtung und umgekehrt durchführen zu können, so daß der für die verschiedenen Bearbeitungsstationen erforderliche Raum möglichst klein und platzsparend gehalten werden kann, ohne daß die Gefahr besteht, daß bei diesen unterschiedlichen Übergaben und Richtungswechsel die empfindlichen Plattenoberflächen durch zusätzliche Greifer, Auflagevorrichtungen beschädigt werden können.

Die überraschende Lösung dieser scheinbar widersprüchlithen Aufgabe besteht erfindungsgemäß darin, daß die Halteelemente während des gesamten Transportes der Platten durch die Bearbeitungsstationen mit den Platten verbunden sind und an Übergängen von einem Vorschubmittel zu einem anderen oder von einer Bearbeitungsstation zur anderen zusammen mit den von ihnen gehaltenen Platten umgesetzt oder umseladen werden.

Die Erfindung sieht also vor, die entsprechenden Greifer oder Klammern zum Erfassen der Plattenrander nicht mehr an den Vorschubmitteln und Transportelementen als deren Bestandteil anzubringen, sondern als gesonderte und einzeln zu handhabende Teile zu gestalten, die nach dem Erfassen der Plattenränder während des Transportes über unterschiedlichste Transportstrecken mit der Platte immer verbunden bleiben, so daß die wechselnden Transporte und die dabei erforderlichen Handhabungen und vor allem die jeweiligen Angriffe neuer Vorschubmittel immer an diesem Halteelement erfolgen können, also die Platte und vor allem deren empfindliche Oberfläche von all diesen Maßnahmen unbeeinflußt bleiben kann. Beim Transport und vor allem beim Übergeben der Platte wird also nicht mehr die Platte selbst jeweils neu erfaßt und übergeben, sondern dies geschieht jeweils mit den Halteelementen, die dabei mit der jeweiligen Platte oder den jeweiligen Platten verbunden bleibt. Es wird also praktisch eine Transportvorrichtung geschaffen, bei welcher die von den einzelnen Transport- und Vorschubmitteln zu tragenden Greifer und Klammern nicht mehr ständige Teile dieser Transport- und Vorschubmittel sind, sondern von diesen nur jeweils bei Bedarf erfaßt und transportiert, im übrigen aber auch weitergegeben werden können. Somit können Kupplungen unterschiedlichster Art von horizontalen, in der Richtung abweichenden und sogar auf- und abwärtsgerichteten Vorschubmitteln an diesen Halteelementen jeweils nacheinander angreifen, was auch den Übergang von einem Vorschubmittel zum nächsten sehr erleichtert.

Besonders zweckmäßig ist es dabei, wenn zwei parallele Halteelemente mit jeweils wenigstens einem Greifer für die beiden in Vorschubrichtung orientierten Längsränder einer Platte vorgesehen sind, die beim Erfassen der Platte auf deren Gesamtbreite einstellbar und danach mit entsprechend zugestellten Transport- und/oder Vorschubmitteln kuppelbar sind. Die erfindungsgemäße Trennung der Halteelemente von den Vorschubmitteln kann also auch die Anpassung an unterschiedliche Plattenabmessungen erleichtern und vereinfachen. Es kann nämlich für jedes Halteelement eines Plattenrandes ein eigenes Vorschubmittel vorgesehen sein, so daß der Abstand dieser parallelen Vorschubmittel sehr leicht an die unterschiedlichen Plattenabmessungen durch Verstellung eines oder beider Vorschubmittel zueinander oder voneinanderweg verändert werden kann, was bei den bisher bekannten Endlosförderern mit integrierten Klammern für zwei Plattenränder nicht oder nur mit sehr aufwendigen Mitteln möglich ist.

Eine konstruktiv besonders einfache Lösung ergibt sich dabei, wenn ein Vorschubmittel für das Halteelement des einen Plattenrandes innerhalb der Transportvorrichtung eine feststehende und festbleibende Bahn und Orientierung hat und das zweite Vorschubmittel für das zweite Halteelement jeweils auf die Breite der zu bearbeitenden Platte in seitlicher Richtung einstellbar ist. Somit braucht bei der Anpassung an unterschiedliche Plattenabmessungen immer nur eine Vorschubbahn adaptiert zu werden.

Für eine definierte und immer gleichbleibende Fixierung der Lage der jeweiligen Platte während ihrer Halterung an dem Halteelement kann es zweckmäßig sein, wenn die Klammer oder der Greifer an dem Halteelement zwei relativ zueinander bewegbare und gegen eine Rückstellkraft voneinanderweg spreizbare Backen hat, deren eine unbeweglich mit einem Gehäuse des Halteelementes verbunden ist oder zu diesem gehört, während die andere Backe auf- und zuschwenkbar ist. Es ergibt sich somit praktisch innerhalb der Klammer eine festliegende Halteebene, da nicht zwei verschwenkbare Klammern oder Backen gegebenenfalls in etwas unterschiedlichen Schwenklagen ihre jeweilige Schließstellung erreichen können.

Um beim Erfassen der Platten möglichst wenig Oberfläche dieser Platte beaufschlagen zu müssen, dennoch aber eine sichere und feste Halterung zu erzielen, ist es vorteilhaft, wenn die Backen des oder der Greifer des Halteelementes jeweils wenigstens zwei in Längsrichtung des Plattenrandes mit Abstand nebeneinander angeordnete, gegen die Plattenoberflächen gerichtete, vorzugsweise spitze Vorsprüngehaben, wobei einander entsprechende Vorsprünge der beiden Backen mit ihren Spitzen einander jeweils etwa gegenüberliegen. Solche spitzen Vorsprünge als die Plattenlängesränder letztlich berührende Teile der Backen können aufgrund der sehr kleinen von ihnen beanspruchten Fläche sehr nah an dem Plattenlängsrand angreifen, dennoch aber eine hohe Haltekraft erzeugen. Somit können sie soweit außerhalb des Bereiches einer Platte bleiben, daß noch ein Sicherheitsabstand zu dem Bereich bleibt, der mit Lack oder Kunststoff überzogen werden soll, was den zusätzlichen Vorteil hat, daß auch diese Greifer oder Klammern auf einfache Weise davor bewahrt werden können, mit Lack oder Kunststoff verunreinigt zu werden.

Es wäre denkbar, für gängige Plattengrößen unterschiedlich lange Halteelemente und insbesondere Halteelemente mit unterschiedlich bemessenen Greifern vorzusehen. Noch vorteilhafter ist es jedoch, wenn an einem Halteelement wenigstens zwei Greifer in Vorschubrichtung und Richtung der Längserstreckung des Halteelementes hintereinander angeordnet sind, die gemeinsam eine große Platte oder gegebenenfalls jeweils eine kleine Einzelplatte beaufschlagen. Somit kann ein solches Halteelement universell sowohl für große als auch für kleine Platten eingesetzt werden und es kann also immer ein Halteelement gleichbleibender Abmessung mit den verschiedenen Transport- und Vorschubmitteln gekuppelt und verbunden werden.

Eine besonders vorteilhafte Ausgestaltung der Erfindung für die Möglichkeit des problemlosen Überganges der Platten aus einer etwa horizontalen in eine auf- und abwärtsfgerichtete Fördervorrichtung kann darin bestehen, daß das Halteelement den Bereich des oder der an ihm befindlichen Greifer in Richtung seiner Längserstreckung um ein Kupplungsende zum Einschieben oder Einstecken in eine taschenförmige Aufnahme eines auf- oder abwärtsführenden Transportmittels überragt. Es ergibt sich dann bei entsprechender Zuordnung eines horizontalen Förderers zu einem solchen nach oben führenden, beispielsweise etwa paternosterartigen Förderer praktisch von selbst, daß das Halteelement durch die Vorschubbewegung auf dem horizontalen Transportmittel selbsttätig mit der Aufnahme dieses neuen Transportmittels gekuppelt werden kann.

Um dabei nach einem anschließenden Übergang wieder auf ein horizontales Transportmittel erneut ein solches nach oben gerichtetes Transportmittel benutzen zu können, ist es dabei vorteilhaft, wenn beide Enden des Halteelementes als Kupplungsenden über den mit Greifern bestückten Bereich vorstehen.

Die Verwendung eines umsetzbaren Halteelementes zum Erfassen der Plattenränder während des Transportes der Platte ermöglicht also eine sehr einfache konstruktive Formgebung für diese Halteelemente, wobei ohne aufwendige zusätzliche Übernahme- und Übergabegreifer dieses Halteelement dennoch sehr leicht von einem Transportmittel auf das andere übergehen kann, indem einfach entsprechende Kupplungsbereiche einerseits für den horizontalen und andererseits für den vertikalen Transport vorgesehen werden. Dabei kommt der Ausgestaltung, die gegenüber den Greifbereichen verlängerten Enden der Halteelemente als Steckkupplungen für entsprechende taschenförmige Aufnahmen eines auf- und abwärtsgerichteten Förderers auszunutzen, aufgrund der Einfachheit und dennoch großen Effektivität dieser Lösung eine erhöhte Bedeutung zu.

Ausgestaltungen der Vorrichtung hinsichtlich der den jeweiligen erfassten Plattenlängsrändern zugewandten Seiten der Greifer-Backen, der Ausgestaltung der bewegbaren Klemmbacke, der Anordnung der Halteelemente am Beginn einer Transportvorrichtung im Zuführbereich der Platten sowie dort für einen vollautomatischen Betrieb vorgesehene Fühler sind Gegenstand der Ansprüche 6 und 10 bis 12. Die Merkmale dieser Ansprüche geben Möglichkeiten an, wie auch die seitliche Ausrichtung und Positionierung der Platten sehr einfach an den Stirnseiten der Klemmbacken maßgenau für die späteren erforderlichen Bearbeitungen erfolgen kann und wie die separat von den einzelnen Förderern und Vorschubmitteln zu handhabenden Halteelemente mit den von ihnen zu erfassenden Platten zu Beginn des jeweiligen Transportvorganges zusammengebracht werden können.

Als Vorschubmittel für die Halteelemente können Schlitten vorgesehen sein, an welchen die Halteelemente lösbar kuppelbar sind. Dies ergibt besonders präzise Vorwärtsbewegungen ohne eventuelle Eigenbewegungen, wie sie in Förderbändern auftreten können. Dabei kann der Schlitten für das Halteelement für den einen Längsrand der Platte mit seinem Vorschubantrieb quer zur Vorschubrichtung verstellbar sein und der Verstellantrieb durch eine oder mehrere der optoelektronischen Fühler zum Abfühlen der Plattengröße im Zuführbereich der gesamten Vorrichtung angesteuert sein. Die schon erwähnte Anpassung der Vorschubmittel an die jeweiligen Plattenabmessungen läßt sich dabei durch die Verwendung von Schlitten als Vorschubmittel besonders einfach bewerkstelligen, weil eine Schlittenbahn eine ausreichende Eigensteifigkeit hat, um auch seitlich gut und präzise verschoben werden zu können.

Ausgestaltungen der Unter- und Oberseite des Halteelementes und der dazu passenden Oberseite des Vorschubschlittens und die in diesem Bereich vorgesehenen Kupplungsmittel zum zeitweiligen lösbaren Verbinden der Halteelemente an den Schlitten sind Gegenstand der Ansprüche 5 bis 18. Vor allem die Verwendung von Indexbolzen an den Schlitten und dazu passende Kupplungsöffnungen an den Halteelementen ergeben einerseits die präzise und lagegenaue lösbare Kupplung zwischen Schlitten und Halteelement, ohne das Halteelement an seinen Oberflächen zu sehr zu zerklüften und dadurch seine Handhabung und auch seine Lagerung und Stapelung beispielsweise in Magazinen zu sehr zu erschweren.

Für den problemlosen Übergang von dem Schlitten in einen paternosterartigen, bereits erwähnten Förderer mit Aufnahmen für die Kupplungsenden des Halteelementes ist es zweckmäßig, wenn das in Vorschubrichtung weisende Kupplungsende des Halteelementes als Steckkupplung zur lösbaren Verbindung mit dem auf- und abwärtsgerichteten Förderer innerhalb einer Vorwärmkammer den Schlitten in Vorschubrichtung überragt. Somit kann der Schlitten mit genügendem Abstand zu diesem weiteren, nach oben gerichteten Vorschubmittel anhalten und dennoch problemlos das Halteelement übergeben. Dabei ist gleichzeitig vorteilhaft, daß ein solcher auf- und abwärtsgerichteter Förderer innerhalb einer Vorwärmkammer angeordnet ist, so daß für das jeweilige Halteelement und vor allem die darin gehaltenen Platten eine genügend lange Verweilzeit zur Vorwärmung erzielt werden kann, ohne daß einerseits der Förderfluß des vollautomatischen Transportes von einer Bearbeitungsstation zur nächsten verlangsamt werden muß, wobei aber dennoch in vorteilhafter Weise für diese Zeit in der Vorwärmkammer mit relativ gesehen praktisch gleichbleibender Vorschubgeschwindigkeit nur sehr wenig Platz in Längsrichtung der gesamten Vorrichtung gebraucht wird. Dabei wird diese Möglichkeit, die Vorwärmung auf engem Raum durch eine Auf- und Abwärtsforderung zu erzielen, durch die vorteilhafte Gestaltung des Halteelementes mit Kupplungsmöglichkeiten einerseits an seinen Unter- und Oberseiten und andererseits an seinen Enden ermöglicht.

Um dabei wiederum aufwendige Klammern, Greifer an dem auf- und abwärtsgerichteten Förderer zu vermeiden und dabei gleichzeitig die Kupplungsenden an dem Halteelement möglichst einfach und glatt gestalten zu können, was auch dem schon erwähnten Übergang von dem Schlitten zu diesem Förderer dadurch zugute kommt, daß die letzte Vorschubbewegung des Schlittens zum Einstecken des Kupplungsendes des Halteelementes in die Aufnahme des Förderers dienen kann, kann der die Halteelemente mit der oder den Platten von den horizontal geführten Schlitten übernehmende Förderer ein aufwärts führendes Trum und ein über eine Umlenkrolle wieder abwärts führendes Trum haben und die von diesen Trums getragenen taschen- oder U-förmigen Aufnahmen sind dabei zweckmäßigerweise in regelmäßigen Abständen neben- bzw. übereinander angeordnet, in welche die Kupplungselemente der Halteelemente passen und so tief einsteckbar sind, daß bei der Aufwärtsbewegung, der Schwenkbewegung im Bereich der oberen Umlenkung und der anschließenden Abwärtsbewegung die beiden parallelen aus den Aufnahmen mit den Greifbereichen und der oder den Platten vorstehenden Halteelemente durch die durch das Einspannmoment erzeugten Reibkräfte festgelegt sind. Praktisch wird also die Verbindung der Halteelemente mit diesen Aufnahmen über eine genügend große Einstecktiefe ausreichend sicher gemacht. Spezielle Klammern, Spreizelemente oder sonstige zu betätigende und zu bewegende Kupplungsmittel können also in vorteilhafter Weise gespart werden, was nicht nur das Einkuppeln der Halteelemente in diese taschenförmigen Aufnahmen erleichtert, sondern ebenso auch auf der anderen Seite die Übergabe aus diesen Aufnahmen wieder an etwa horizontal verschiebliche Fördermittel, insbesondere Schlitten, problemlos und einfach macht.

Eine Ausgestaltung des gesamten Verfahrens von eigener schutzwürdiger Bedeutung kann dabei darin bestehen, daß das aufwärtsführende Trum und/oder das abwärtsführende Trum des oder der Auf- und Abwärtsförderer der Vorrichtung zur Vertikalen unter einem spitzen Winkel derart geneigt sind, daß die beiden Trums in dem oberen Bereich des Förderers einen geringeren Abstand zueinander als im unteren Bereich haben. Dadurch laufen also die Trums nicht genau in vertikaler Richtung, sondern sind dazu leicht schräg geneigt. Dies hat den erheblichen Vorteil, daß an den Steckverbindungen zwischen Halteelement und Aufnahme ein gewisses Spiel möglich ist, ohne daß die an dem Trum einseitig vorstehenden Halteelemente während ihres auf- und abwärtsgerichteten Transportes jeweils mit ihrem freien Ende schräg nach unten hängen. Somit wird das Einschieben erleichtert, die Herstellung der Kupplungsverbindung aufgrund der größeren Toleranzmöglichkeiten verbilligt und dennoch eine gute Sicherheit dieser einfachen Steckkupplung während des gesamten Transportes erzielt. Am einfachsten läßt sich diese schräge Anordnung der Trums dadurch erreichen, daß die obere Umlenkrolle oder -walze des Förderers einen kleineren Durchmesser als die untere Umlenkung hat und die beiden Trums symmetrisch zu einer vertikalen Ebene durch die Achsen der beiden Umlenkungen angeordnet sind. Dadurch wird gleichzeitig sichergestellt, daß die Halteelemente sowohl vor als auch nach ihrer oberen Umlenkung aufgrund einer weitgehend symmetrischen Gestaltung ihrer Kupplungsenden relativ zu einer horizontalen Ebene an beiden Trums jeweils etwa horizontal ausgerichtet sind.

Ausgestaltungen der U- oder taschenförmigen Aufnahmen, die vor allem einerseits für eine lagegenaue Beibehaltung der Positionierung der Platten in Vorschubrichtung, andererseits aber auch für eine problemlose Anpassung an unterschiedliche Abmessungen von Platten vorteilhaft sind, sind Gegenstand der Ansprüche 22 und 25.

Anspruch 26 präzisiert die Maßnahmen betreffend der Schrägstellung der Trums zu einer Vertikalen, um dabei eine möglichst genaue horizontale Ausrichtung der Halteelemente während ihres Transportes nach oben und wieder nach unten zu erhalten.

Am unteren Endbereich des abwärtsführenden Trums des Förderers kann eine horizontale Führungsbahn mit Schlitten zur Übernahme der Halteelemente mit den Platten vorgesehen sein, die zu einer Auftragvorrichtung für Schutz- oder Lötstopp-Lack oder -Kunststoff führt, innerhalb welcher vorzugsweise die nach oben weisende Seite der Platte mit diesem Lack oder Kunststoff beschichtet wird. Dabei kann in dieser Auftragvorrichtung ein Lackbegrenzer vorgesehen sein, der von optoelektronischen Fühlern, vorzugsweise denen am Einlauf in die Vorrichtung, angesteuert ist und einen Lackauftrag auf die Halteelemente und die daran befindlichen Greifer verhindert.

Die horizontale Führungsbahn kann durch die Lackauftragvorrichtung hindurch in eine Trockenkammer führen, in welcher ein Auf- und Abwärtsförderer - entsprechend dem Auf- und Abwärtsförderer in der Vorwärmkammer - angeordnet sein kann, wobei die Vorschubgeschwindigkeit und die Höhe dieses Förderers so gewählt sind, daß die auf der Oberseite der Platte befindliche Lackschicht während des Transportes nach oben soweit angetrocknet ist, daß sie beim Umwenden und Abwärtsfördern nicht mehr verläuft.

Das vorteilhafte Förderprinzip mit Hilfe der von einem Förderelement und Vorschubmittel zum nächsten zu übergebenden Halteelemente mit den Platten ermöglicht es, daß sich im unteren Übergabebereich des abwärtsführenden Trums des Förderers der Trockenkammer eine weitere horizontale Führungsbahn mit Schlitten anschließt und die abwärts geförderten Halteelemente mit dort angeordneten Schlitten kuppelbar und in eine weitere Lackauftragsvorrichtung förderbar sind, die der ersten Lackauftragvorrichtung vorzugsweise entspricht. Der platzsparende Förderer der Trockenkammer mit einem auf- und einem abwärtsgerichteten Trum wendet nämlich auf diesem Förderweg zwangsläufig die Platte, so daß ganz von selbst die noch nicht beschichtete Oberfläche der Platte am Ende dieses Förderers nach oben gerichtet ist, so daß sie problemlos in eine nachgeschaltete weitere Lackauftragstation transportiert werden kann, so daß also die verschiedenen Arbeitsstationen konstruktiv praktisch übereinstimmend gestaltet werden können.

An die zweite Lackauftragvorrichtung kann sich wenigstens eine weitere Trockenkammer mit einem Auf- und Abwärtsförderer anschließen - der in vorteilhafter Weise wiederum den schon vorerwähnten derartigen Förderern hinsichtlich Kupplungen und Übernahme und Abgabe der Halteelemente entsprechen kann - und hinter dieser Trockenkammer oder wenigstens einer weiteren Trockenkammer kann eine Auslaufbahn angeordnet sein.

Insgesamt ergibt sich somit ein Förderweg für die Platten, dessen Hauptmerkmal darin besteht, daß nicht die Platten jeweils von einem Fördermittel zum nächsten übergeben werden, sondern daß dies mit Halteelementen geschieht, die dabei ständig mit den Platten verbunden bleiben. Dabei sind praktisch nur zwei Sorten von Fördermitteln erforderlich, nämlich solche für eine Horizontalbewegung und solche für eine die gesamte Vorrichtung platzsparend gestaltende Auf- und Abwärtsbewegung, was den weiteren Vorteil hat, daß die dabei jeweils notwendigen Kupplungsstellen an dem Halteelement voneinander getrennt und auch in Vorschubrichtung so zueinander zugeordnet sein können, daß die jeweiligen Bewegungen der horizontalen Fördermittel für das Ein- und Auskuppeln an dem auf- und abwärtsgerichteten Förderer sorgen können.

Weitere Ausgestaltungen der Gesamtvorrichtung insbesondere in ihrem Auslauf mit Möglichkeiten, die dann nicht mehr benötigten Halteelemente wieder in Ausgangslage zu bringen, um erneut Platten damit transportieren zu können, sind Gegenstand der Ansprüche 32 und 33.

Insgesamt ergibt sich ein Transportverfahren, dessen Herzstück die Verwendung eines Halteelementes ist, womit die zu transportierenden Platten erfaßt und dann während des Transportes und der Behandlung mit unterschiedlichsten Transportmitteln und in unterschiedlichsten Arbeitsstationen immer verbunden bleiben, so daß die Plattenoberflächen geschont werden und die für die Platten gefährlichen Kupplungen und Halterungen an die Halteelemente verlegt sind. Dies ermöglicht die erwähnten zweckmäßigen und platzparenden Anordnungen unterschiedlicher Arbeitsstationen, so daß beispielsweise Leiterplatten praktisch vollautomatisch beidseits mit Kunststoff oder Lack beschichtet werden können.

Nachstehend ist die Erfindung mit ihren ihr als wesentlich zugehörenden Einzelheiten anhand der Zeichnung in einem Ausführungsbeispiel noch näher beschrieben.

Es zeigt in zum Teil schematisierter Darstellung:

Fig. 1 eine Gesamtansicht einer Transportvorrichtung,

Fig. 2 eine Draufsicht eines Halteelementes, welches mit Greifern eine Platte in deren Randbereich erfaßt und während des gesamten Vorschubes mittels verschiedenen Fördermitteln in der Transportvorrichtung mit der Platte verbunden bleibt,

Fig. 3 einen Querschnitt durch zwei die Längsränder einer Platte mit Hilfe ihrer Greifer erfassende Halteelemente,

Fig. 4 eine Seitenansicht und

Fig. 5 eine Draufsicht einer allerersten Station der Transportvorrichtung, wo die aufgegebenen Leiterplatten und ihre Abmessungen elektrooptisch und/oder mechanisch erfaßt und die Leiterplatten zur Breitenerkennung ausgerichtet werden,

Fig. 6 eine Ansicht der Vorrichtung zum Ausrichten der Leiterplatten für ihre Breitenerkennung mit Blickrichtung in Vorschubrichtung auf die quer zu den zu erfassenden Längsrändern verlaufende Stirnseite einer Leiterplatte,

Fig. 7 eine Draufsicht der Breitenerkennung der Leiterplatte gemäß Fig. 6,

Fig. 8 eine Stirnansicht der Station der Transportvorrichtung, wo die Halteelemente mit den ausgerichteten Platten verbunden werden, wobei die Greifer geöffnet sind,

Fig. 9 eine der Fig. 8 entsprechende Darstellung nach dem Schließen der Greifer und dem Erfassen der Plattenränder,

Fig. 10 die Zuführstation für die Halteelemente gemäß den Figuren 8 und 9, dabei aber nur den Funktionsablauf der Zufuhr der Halteelemente,

Fig. 11 eine Draufsicht der Zufuhrstation für die Halteelemente, wobei ein Greiferkopf eines Handlinggerätes für ein jeweiliges Halteelement dieses erfaßt und zentriert.

Fig. 12 eine Stirnansicht der Station zur Zufuhr der Halteelemente zu den zu erfassenden Platten, wobei die gemäß Fig. 11 erfassten Halteelemente angehoben und bis auf die vorerkannte Breite der Platten aufeinanderzu bewegt werden.

Fig. 13 eine der Fig. 12 entsprechende Darstellung, bei welcher die Halteelemente abgesenkt und auf ihre Transportschlitten gelegt sind,

Fig. 14 den Öffnungsvorgang der Greifer der Halteelemente gegen eine Rückstellkraft,

Fig. 15 die endgültige Einstellung des Abstandes zwischen den beiden Halteelementen und dabei das Untergreifen der zu erfassenden Halteplatte mit der unteren feststehenden Klemmbacke des Halteelementes,

Fig. 16 das Schließen der Greifer der Halteelemente und damit das Verbinden mit den Plattenrändern,

Fig. 17 eine der Fig. 11 entsprechende Darstellung, wobei die die Halteelemente erfassenden Greiferköpfe geöffnet werden, wonach die Leiterplatte mit ihren Halteelementen frei auf den Schlitten aufliegt,

Fig. 18 das Abrücken der Greiferköpfe für die Halteelemente in deren Ausgangsstellung,

Fig. 19 eine Seitenansicht der Zufuhr der Halteelemente zu einem auf- und abwärtsführenden Förderer beispielsweise in einer Trockenkammer, wobei dieser auf- und abwärtsführende Förderer jeweils schrittweise um den Abstand einer Aufnahme für ein Halteelement weiterbewegt wird, sowie

Fig. 20 in vergrößertem Maßstab und teilweise im Schnitt die Verbindung zwischen einem Kupplungsende eines Halteelementes und einer Aufnahme an dem auf- und abwärtsführenden Förderer.

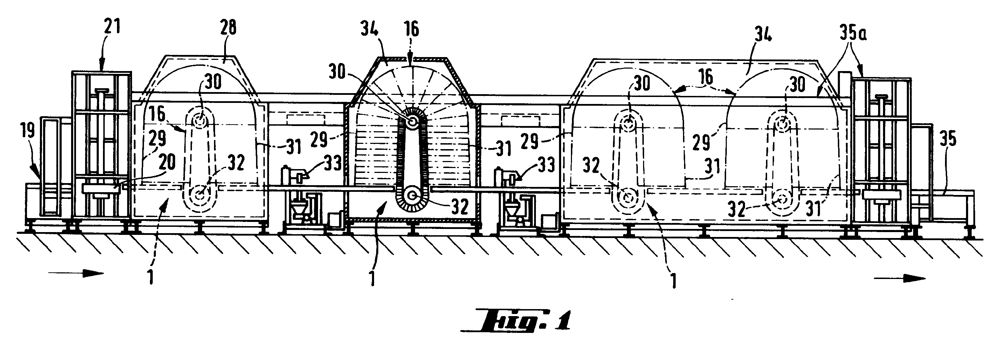

In Fig. 1 ist ein Beispiel einer im ganzen mit 1 bezeichneten Transportvorrichtung für Platten oder plattenförmige Werkstücke 2 dargestellt, wobei es in diesem speziellen Fall um Leiterplatten 2 geht, deren Oberfläche mit UV-härtbarem Kunststoff beschichtet und vor dieser Beschichtung vorgewärmt werden soll, wobei eine beidseitige Beschichtung und zwischen diesen beiden Beschichtungsvorgängen ein Vortrocknungsvorgang und nach den Beschichtungen eine endgültige Trocknung vorgesehen sind. Die Transportvorrichtung 1 führt also über einzelne, jeweils noch zu beschreibende Vorschubmittel und Förderer zu verschiedenen Arbeitsstationen, wobei das Werkstück, nämlich die Platte 2 teilweise die Richtung und auch das Vorschubmittel wechseln muß.

Anstelle der Anordnung verschiedener Fördermittel und Bearbeitungsstationen gemäß Fig. 1 könnte aber die Transportvorrichtung 1 mit wechselnden Vorschubmitteln auch für andere Handhabungen und Bearbeitungen von plattenförmigen Werkstücken angepaßt sein und zu jeweils anderen Arbeitsstationen in anderer Reihenfolge und Zusammensetzung führen.

Wichtig ist jeweils, daß die Vorrichtung 1 Greifer 3 zum Erfassen der Plattenränder 4 während des Transportes und des Vorschubes der Platten 2 zu den und durch die Bearbeitungsstationen hindurch aufweist, so daß die übrige Plattenfläche freibleibt und nicht beschädigt und beeinträchtigt werden kann.

Um nun das Umsetzen der Platten 2 bei dem Wechsel von einem Fördermittel oder Vorschubmittel zu dem anderen und zu den Arbeitsstationen möglichst ohne Gefahren für die empfindlichen Platten gestalten zu können, ist ein Kernstück der Vorrichtung 1 ein mit den Transport- oder Vorschubmitteln der Vorrichtung 1 lösbar kuppelbares Halteelement 5 oder Rack, an welchem der oder die Greifer 3 oder Klammern zum Erfassen der Plattenränder 4 vorgesehen sind.

Dieses in noch zu beschreibender Weise mit den Transport- und Vorschubmitteln lösbar kuppelbare Haltelement 5 oder Rack bleibt also während des gesamten Transportes und der gesamten Bearbeitung der Platten 2 mit diesen verbunden oder - umgekehrt ausgedrückt - selbst beim Wechsel von einem Vorschubmittel zum andern braucht der oder die Greifer 3 an den Plattenrändern 4 niemals geöffnet zu werden, so daß all diese Umsetzvorgänge die Platte 2 selbst nicht berühren. Stattdessen wird das Halteelement 5 während des gesamten Transportes der Platte 2 mit dieser verbunden jeweils an Übergängen von einem Vorschubmittel zu einem anderen oder von einer Arbeitsstation zur anderen zusammen mit dieser von ihm gehaltenen Platte 2 umgesetzt und umgeladen.

Praktisch ist also die bisher an Vorschubmitteln vorgesehene Haltevorrichtung für Platten nicht mehr an diesen Vorschubmitteln selbst integriert, sondern von diesen gelöst und kann von Vorschubmittel zu Vorschubmittel weitergegeben werden.

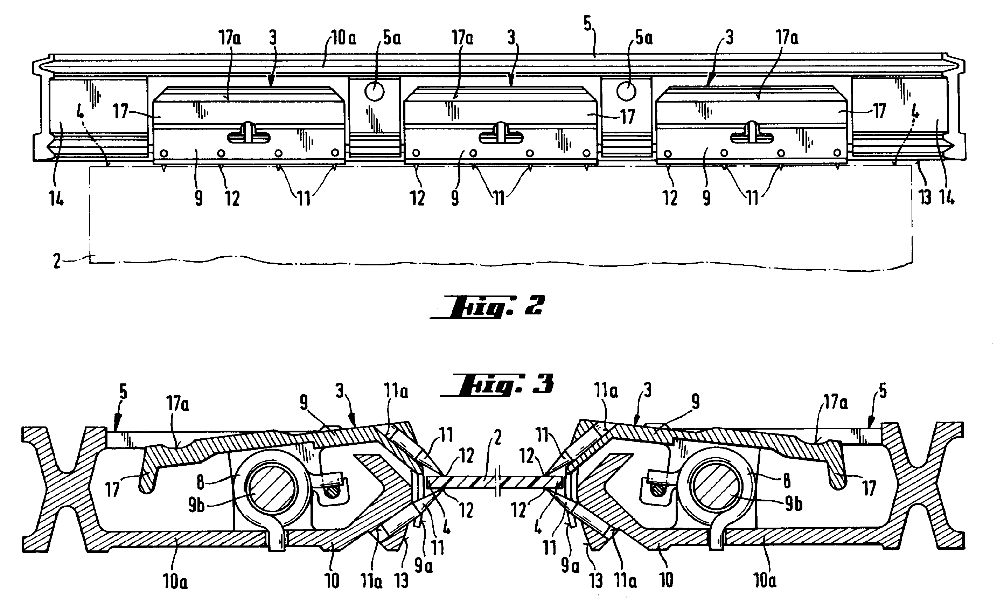

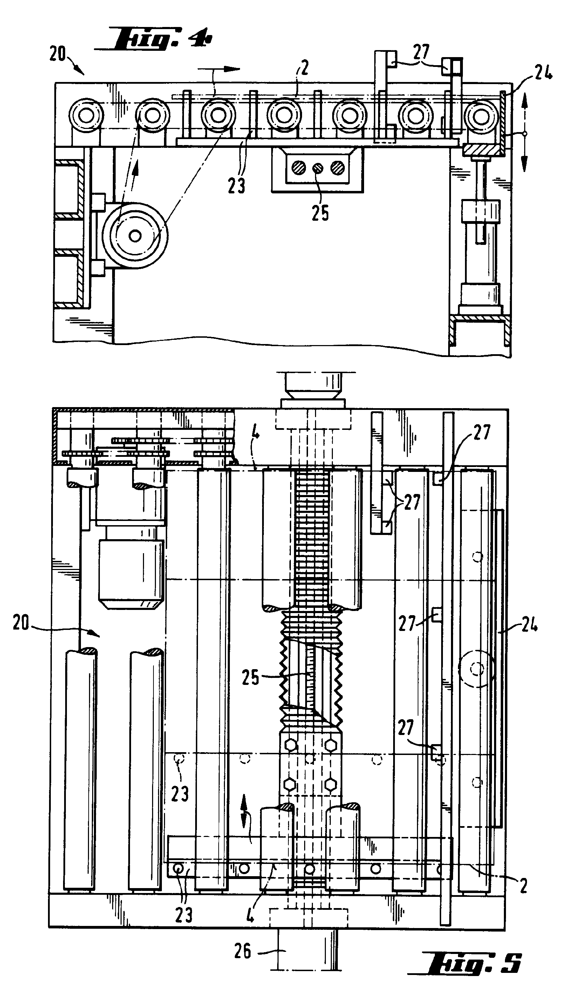

Dieses für die Erfindung wichtige Halteelement 5 ist vor allem in den Figuren 2 und 3 gesondert und vergrößert dargestellt, während seine Handhabung und sein Zusammenwirken mit den Vorschubmitteln in weiteren Figuren erkennbar ist und anhand dieser Figuren beschrieben wird.

Zunächst erkennt man in Fig. 3, daß zwei parallele Halteelemente 5 mit jeweils wenigstens einem Greifer 3, in diesem Ausführungsbeispiel gemäß Fig. 2 mit drei Greifern 3, für die beiden in Vorschubrichtung orientierten Längsränder 4 einer Platte 2 vorgesehen sind, die beim Erfassen der Platte 2 in an weiteren Figuren noch zu beschreibender Weise auf deren Gesamtbreite einstellbar und danach mit entsprechend zugestellten Transport- und/oder Vorschubmitteln kuppelbar sind.

An dieser Stelle sei schon darauf hingewiesen, daß ein Vorschubmittel, nämlich im Ausführungsbeispiel ein in Vorschubrichtung verschiebbarer Schlitten 6 für das Halteelement 5 das einen Plattenrandes 4 innerhalb der Transportvorrichtung 1 eine feststehende und festbleibende Bahn und Orientierung hat und das zweite, wiederum als Schlitten 7 ausgebildete Vorschubmittel für das zweite Halteelement 5 jeweils auf die Breite der zu bearbeitenden Platte 2 in seitlicher Richtung einstellbar ist.

Die Verwendung von zwei parallelen Halteelementen 5 gemäß Fig. 3 kann also nicht nur für eine Abmessung einer Platte 2, sondern für beliebige Plattenbreiten Anwendung finden, wenn die vorstehend beschriebene Maßnahme der seitlichen Verstellbarkeit wenigstens eines Vorschubmittels erfüllt ist. Dabei ist eine Besonderheit dieser Maßnahme, daß praktisch zwei voneinander unabhängige, aber synchron antreibbare parallele Vorschubmittel vorgesehen sind, die die erwähnte Veränderung ihres gegenseitigen Abstandes erlauben. Die Vorschubmittel sind somit daran angepaßt, daß die Halteelemente 5 für die beiden Plattenränder 4 voneinander getrennt und unabhängig sind, während bei üblichen Vorschubmitteln deren Breite in der Regel feststeht und eine Anpassung an unterschiedlich breite Werkstücke sehr aufwendig ist.

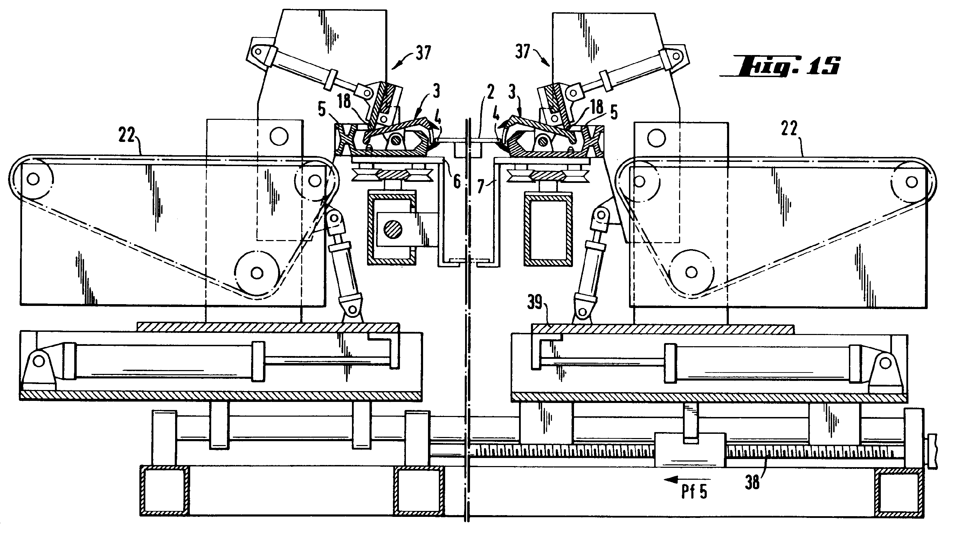

Die Kammer bzw. der Greifer 3 an dem Halteelement 5 hat zwei relativ zueinander bewegbare, gegen eine Rückstellkraft einer Feder 8 voneinander wegspreizbare Backen 9 und 10. Dabei ist die in Fig. 3 jeweils untere Backe 10 unbeweglich mit dem Gehäuse 10a des Halteelementes 5 verbunden und gehört zu diesem, während die andere, in Fig. 3 oben befindliche Backe 9 auf- und zuschwenkbar ist, wie man es anhand der Figuren 13 bis 16 im folgenden noch erkennen wird. Die Backen 9 und 10 des oder der Greifer 3 des Halteelementes 5 haben zum Erfassen eines Randes 4 einer Platte 2 jeweils wenigstens zwei, gemäß Fig. 2 sogar vier in Längsrichtung des Plattenrandes 4 mit Abstand nebeneinander angeordnete, gegen die Plattenoverflächen gerichtete, vorzugsweise spitze Vorsprünge 11, wobei einander entsprechende Vorsprünge 11 der beiden Backen 9 und 10 mit ihren Spitzen 12 gemäß Fig. 3 einander jeweils etwa gegenüberliegen, um die Klemmkräfte an ein und derselben Stelle einleiten zu können. Diese spitzen Vorsprünge 11 beanspruchen also an der Plattenoberfläche nur sehr wenig Raum und können gemäß Fig. 2 sehr nah an dem Längsrand 4 angreifen, beeinträchtigen also die Plattenoberfläche praktisch nicht. Insbesondere gilt dies für Leiterplatten, die immer einen gewissen äußeren freien Rand haben, der auch nicht zu beschichten ist. Die Vorsprünge 11 sitzen dabei also Stifte in Löchern 11a. In Fig. 3 erkennt man, daß die gegenüber der feststehenden Backe 10 hochschwenkbare Gegenbacken 9 eine gerundete Stirnseite 9a hat, deren Krümmungsradius dem Schwenkradius dieser Stirnseite um die Schwenkachse 9b dieser Klemmbacke 9 entspricht. Diese gekrümmte Stirnseite 9a greift dabei über eine analog gekrümmte Stirnseite 13 der feststehenden Backe 10. Dabei überragt die Stirnseite 9a außerdem die Vorsprünge 11, so daß sie selbst bei geöffneter Klemmbacke 9 einen Seitenanschlag für die Leiterplatte 2 bilden kann, der sich aufgrund der gekrümmten Oberfläche während des Schließens der Backe auch nicht bezüglich seiner Seitenlage verändert.

Wie bereits erwähnt, können an einem Halteelement 5 mehrere, z.B. drei, evtl. aber auch nur zwei, andererseits aber auch vier oder fünf Greifer 3 in Vorschubrichtung und Richtung der Längserstreckung des Halteelmentes 5 hintereinander angeordnet sein, die Gemäß Fig. 2 gemeinsam eine große Platte 2 oder gegebenenfalls jeweils kleine Einzelplatten beaufschlagen können. Dadurch können gleichzeitig bei großen Platten unter Umständen vorliegende Verwindungen od.dgl. Unebenheiten ausgeglichen werden und entlang des gesamten Längsrandes die gewünschte Haltekraft mit großer Sicherheit aufgebracht werden.

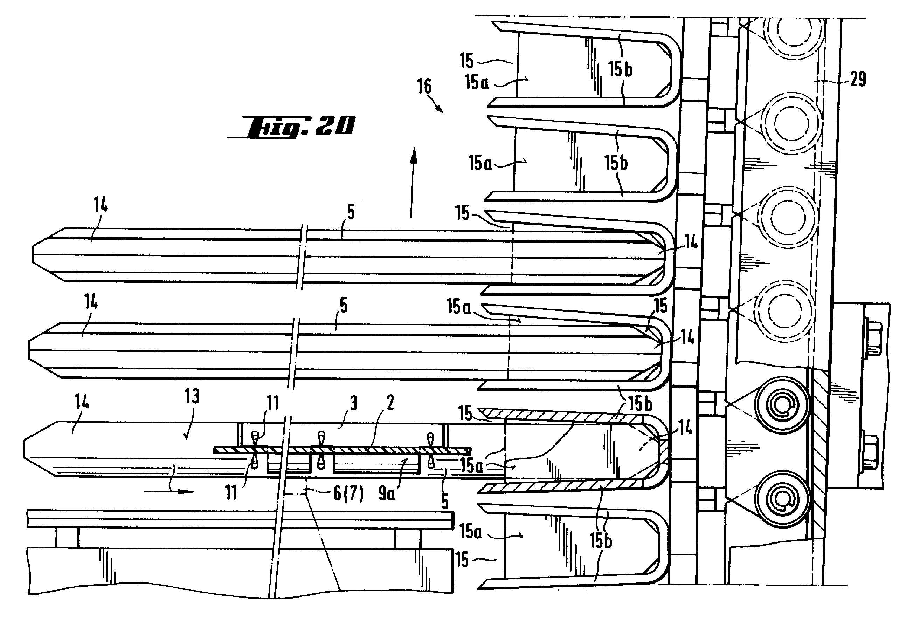

In Fig. 2, vor allem aber in Fig. 19 und 20 erkennt man, daß das Halteelement 5 den Bereich des oder der an ihm befindlichen Greifer 3 in Richtung seiner Längserstreckung um ein Kupplungsende 14 zum Einschieben oder Einstecken in eine taschenfömige Aufnahme 15 eines auf- und abwärtsführenden Transportmittels 16 überragt. Dabei wird in den genannten Figuren deutlich, daß sogar beide Enden des Halteelementes 5 als Kupplungsenden 14 über den mit Greifern 3 bestückten Bereich vorstehen. Somit ist die Übergabe dieses Halteelementes 5 mit einer von ihm erfassten Platte 2 von einem horizontal wirkenden Vorschubelement in ein auf- und abwärtsführendes Transportmittel 16 sehr einfach möglich, wie es anhand der genannten Figuren noch beschrieben wird.

Anhand der Fig. 3 erkennt man eine Möglichkeit, wie die bewegliche Klemmbacke 9 für eine möglichst gute und automatische Betätigung auf der in Längsrichtung des Halteelementes 5 orientierten Schwenkachse 9b wippenartig gelagert und wippenartig ausgebildet ist und der dem Backenteil mit den Vorsprüngen 11 an der Achse 9b gegenüberliegende Überstand 17 als Betätigungsbereich zum Zusammenwirken mit einem ihn von oben her beaufschlagenden Betätigungselement 18 für das Hochschwenken der Schwenkbacke 9 gegen die Rückstellkraft der Feder 8 vorgesehen ist. Man erkennt an der Oberseite des Überstandes 17 eine Kerbe 17a, die den sicheren Angriff des Betätigungselementes 18 von oben her auch dann gewährleistet, wenn eine gewisse Schwenkbewegung durchgeführt ist.

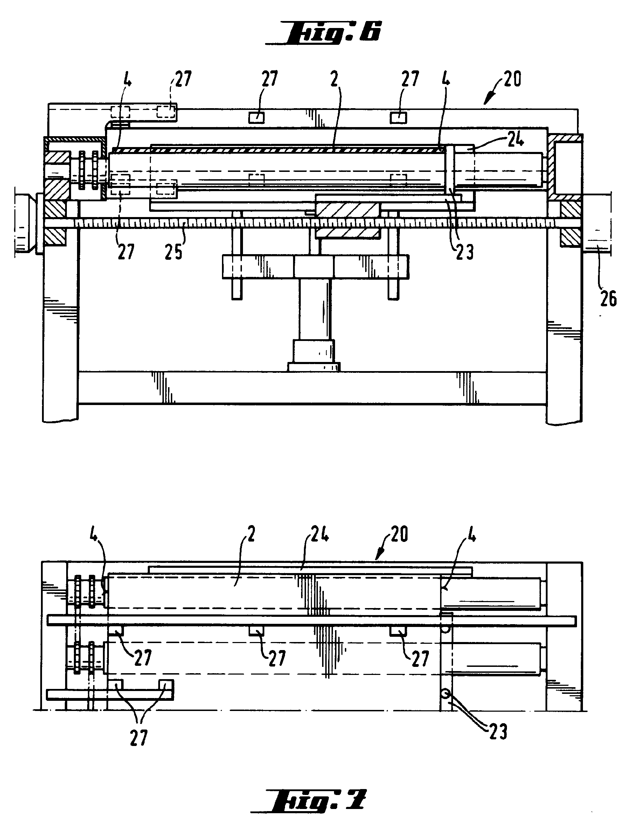

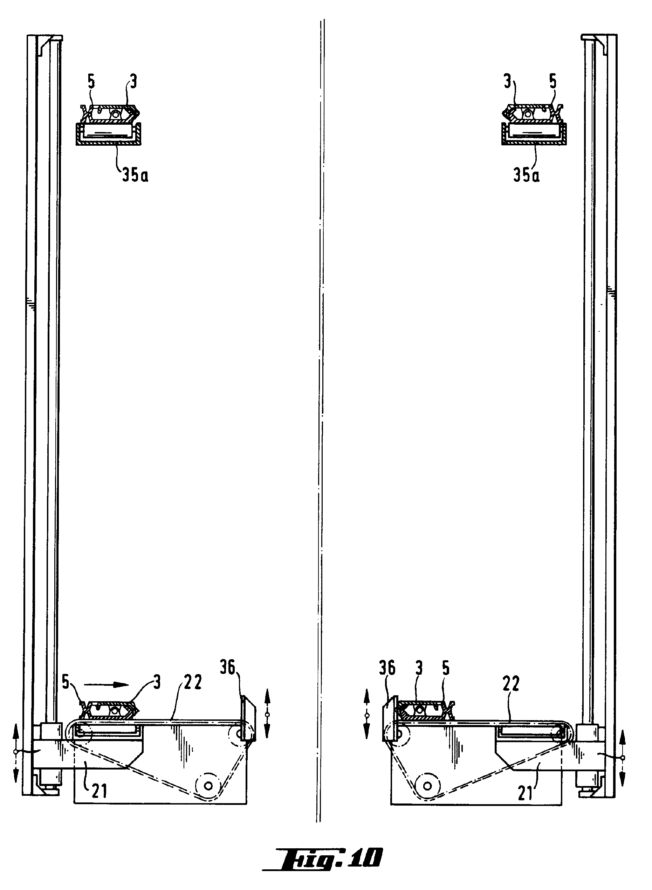

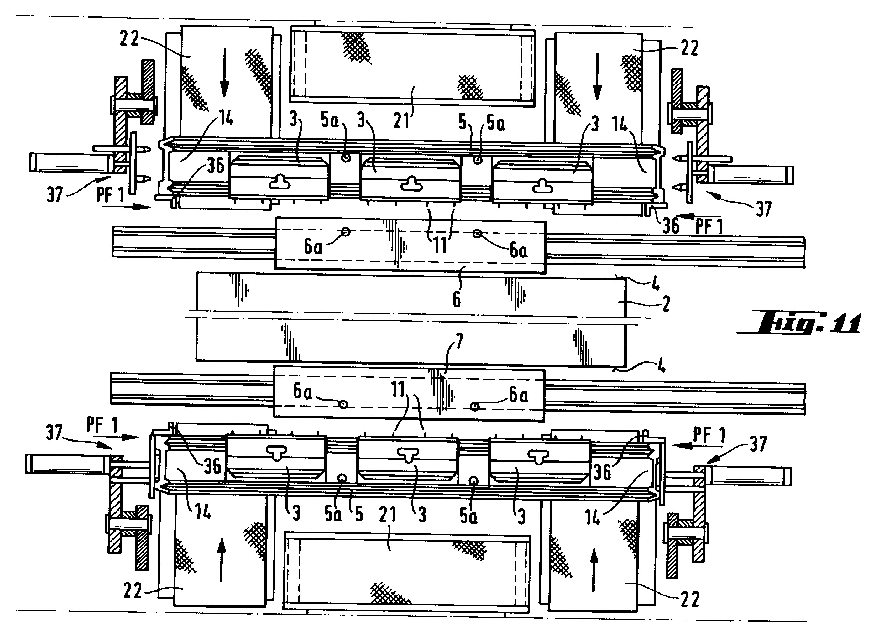

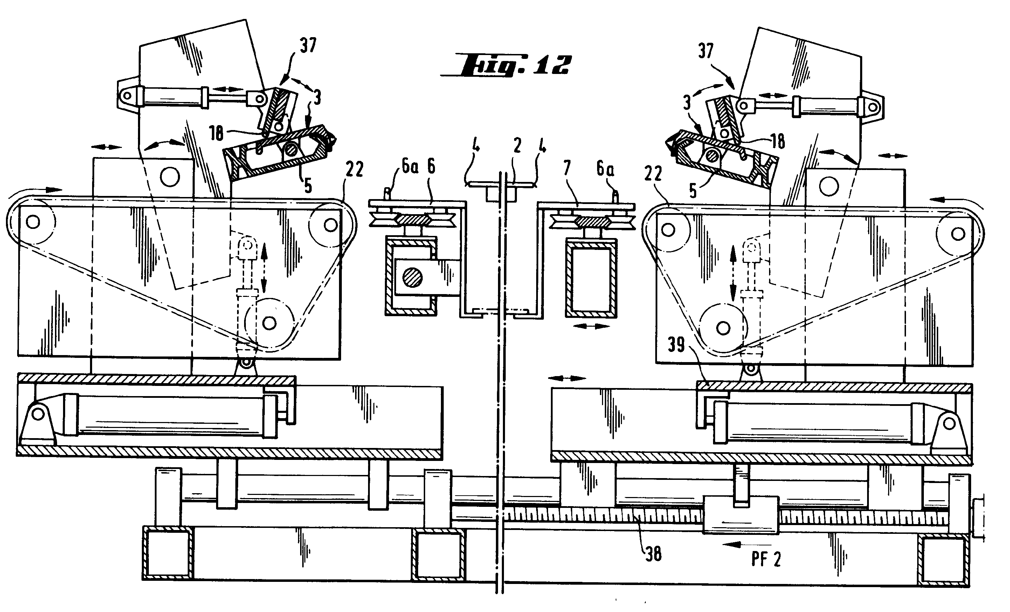

Gemäss den Figuren 8 bis 10 werden die Halteelemente 5 mit den Greifern 3 von im Zuführbereich 19 (Fig. 1) der Platten 2 in die Vorrichtung 1 seitlich von einer in Vorschubrichtung der Platten 2 gerichteten Zuführbahn 20 (Fig. 4 bis 7) angeordneten Liften 21, die man auch in Fig. 1 erkennt, angeliefert. Unterhalb der Lifte 21 befinden sich quer zur Vorschubrichtung der Platten 2 angeordnete Fördermittel, gemäss Fig. 10 im Ausführungsbeispiel schrittweise bewegbare Förderbänder 22, womit jeweils ein einzelnes Halteelement 5 von der Seite her den Vorschubmitteln 6 und 7 zugeführt wird. Auch dies dient dazu, die seitlichen Plattenränder gut erfassen zu können und dabei Platten 2 unterschiedlicher Abmessungen berücksichtigen zu können.

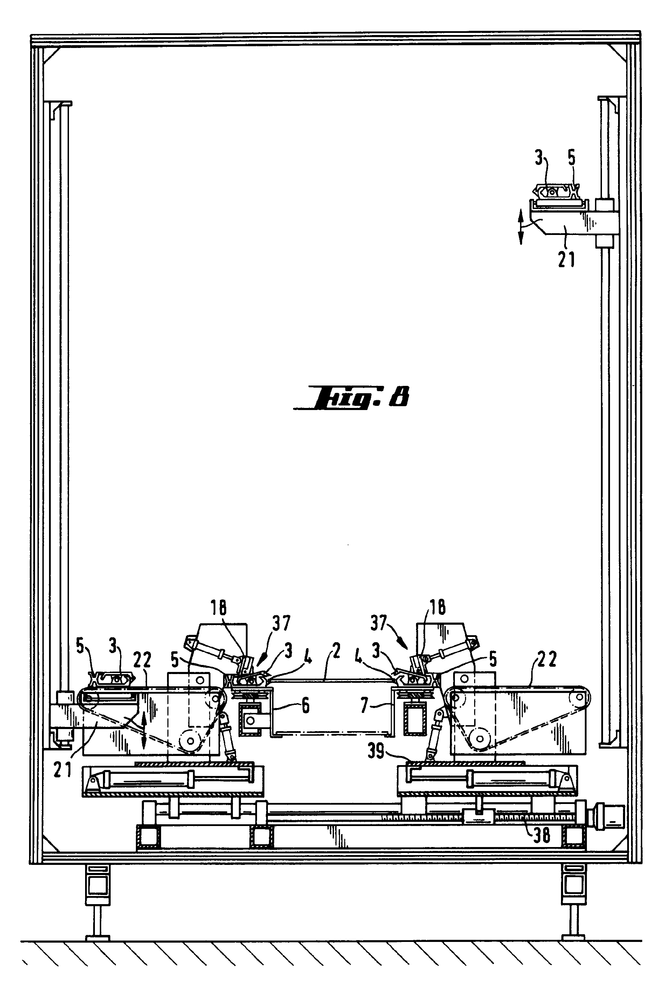

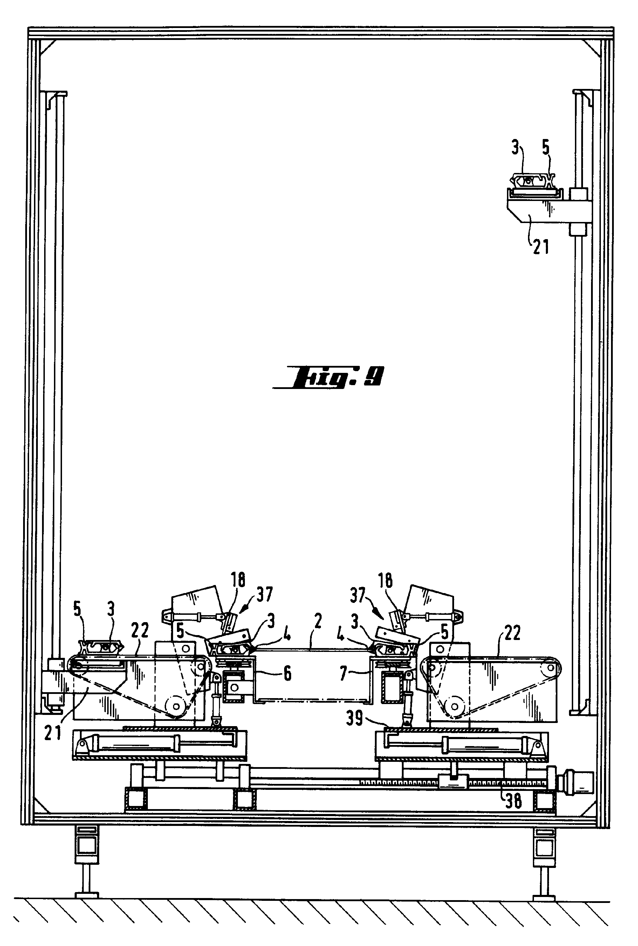

Im Bereich der Zuführbahn 20, gemäß den Figuren 4 bis 7 einer Rollbahn, für die einzelne Platte 2 in die Vorrichtung 1 hinein sind durch deren Abmessungen beaufschlagte Fühler, z.B. optoelektronische Fühler, Lichtschranken od.dgl. vorgesehen, die den Antrieb für die Zuführung der Halteelemente 5, also für die bevorzugt als Zahnriemen ausgebildeten Förderbänder 22, und den Antrieb für die Betätigungsvorrichtungen 18 zum Öffnen der Greifer 3 ansteuern. Zuvor sorgen sie allerdings über einen Rechen 23 und einen absenkbaren Anschlag 24 für die Vorerkennung und Ausrichtung der einzelnen Leiterplatte 2, wie man es in Fig. 4 und 5 erkennt. Der für die seitliche Ausrichtung vorgesehene Rechen 23 und sein Antrieb mit Hilfe einer Spindel 25 und einem Antriebsmotor 26 ist vor allem in Fig. 6 dargestellt. Dort erkennt man außerdem Lichtschranken 27 zum Abfühlen weiterer Plattenränder.

Es wurde schon erwähnt, daß als Vorschubmittel für die Halteelemente 5 Schlitten 6 und 7 vorgesehen sind, an welchen die Halteelemente 5 in noch zu beschreibender Weise lösbar kuppelbar sind. Dabei ist der Schlitten 7 für den einen Längsrand 4 der Platte 2 zusammen mit seinem Vorschubantrieb, wie ebenfalls bereits erwähnt, quer zur Vorschubrichtung verstellbar. Der dazu dienende, nicht näher dargestellte Verstellantrieb ist nun wiederum durch eine oder mehrere der optoelektronischen Fühler und Anschläge angesteuert, um vollautomatisch die Anpassung an unterschiedliche Plattengrößen zu erlauben.

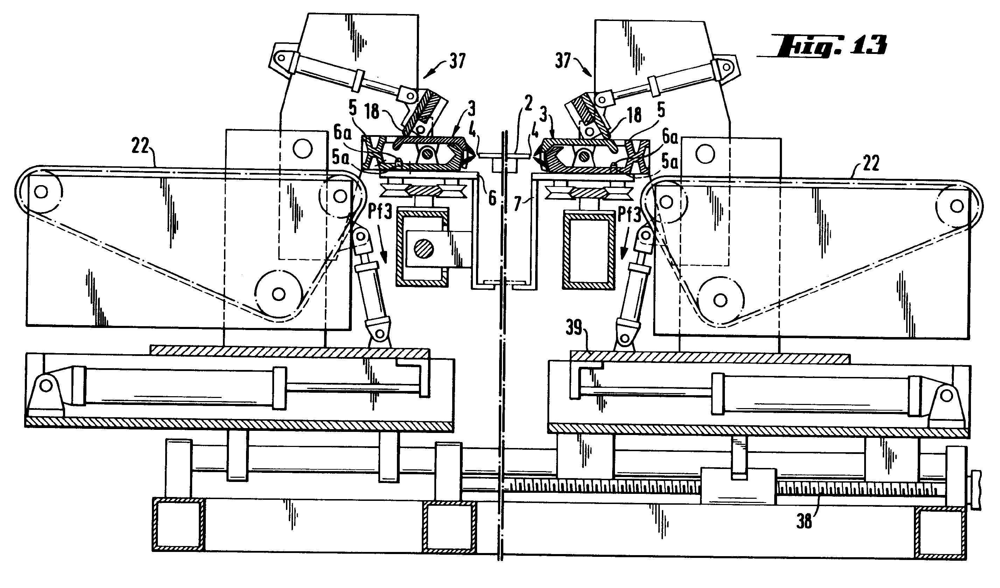

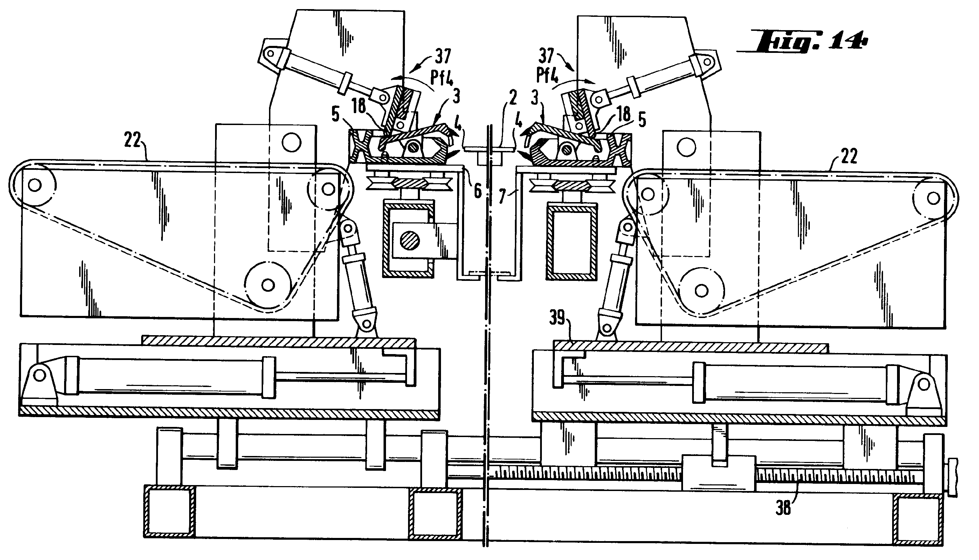

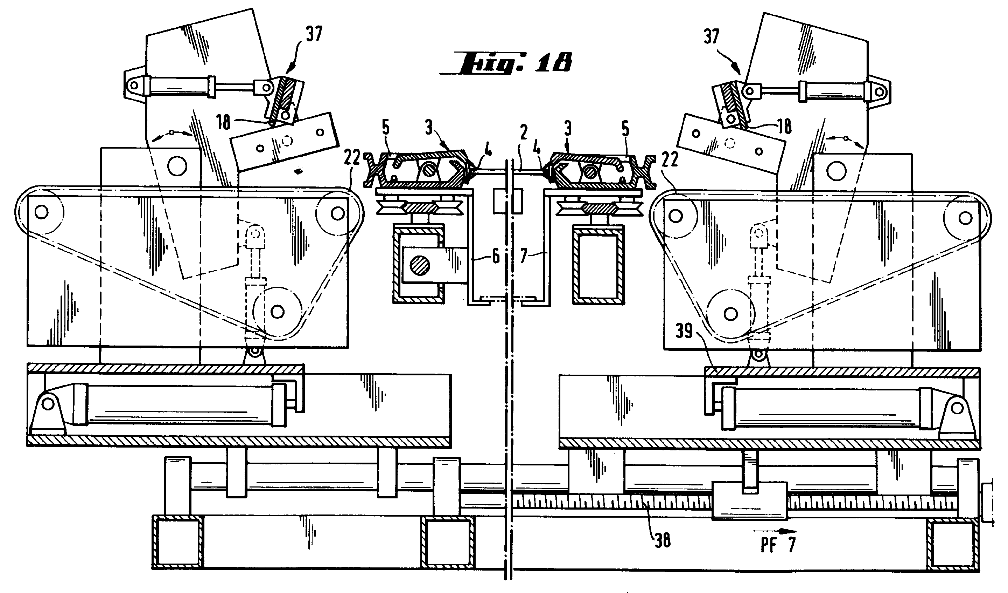

Die im Ausführungsbeispiel gemäß Fig. 3 und 20 flach und eben ausgebildete Unterseite des Halteelementes 5 paßt auf eine entsprechend ausgebildete Oberseite der Vorschubschlitten 6 und 7 und diese einander berührenden Flächen haben die Kupplungsmittel für die lösbare Kupplung zwischen Schlitten und Halteelement. In der besseren Übersichtlichkeit wegen nicht näher dargestellter Weise können dabei als besonders einfache Kupplungsmittel Lochungen in dem einen Teil und in diese passende Vorsprünge, Stifte od. dgl. in dem anderen Teil vorgesehen sein. Damit dabei das für die Erfindung wichtige Halteelement 5, welches möglichst problemlos auch von einem Vorschubmittel zu einem anderen übergeben und in unterschiedlicher Weise bewegt und gehandelt werden können soll, ist es vorteilhaft, wenn die Kupplungslochung oder mehrere Kupplungslochungen 5a (Fig. 11 und 17) an dem Halteelement 5 und der oder die Kupplungsstifte oder -vorsprünge 6a (Fig. 12) an der Oberseite der Vorschubschlitten 6 und 7 angeordnet sind. Der Kupplungsvorsprung paßt dabei zweckmäßigerweise als Indexbolzen mit einer Passung in die Kupplungsöffnung und hat vorzugsweise ein sich verjüngendes freies Ende zur Zentrierung beim Einführen in die Kupplungsöffnung. Dadurch wird beim Kuppeln auch gleich die lagegenaue Positionierung des Halteelemetes 5 auf dem Schlitten 6 oder 7 erreicht.

Anhand der Figures 19 und 20 erkennt man, daß das jeweils in Vorschubrichtung weisende Kupplungsende 14 des Halteelementes 5 als Steckkupplung zur lösbaren Verbindung mit dem auf- und abwärtsgerichteten Förderer 16 innerhalb einer Vorwärmkammer 28 den Schlitten 6 und 7 in Vorschubrichtung überragt. Dadurch wird erreicht, daß die Schlitten 6 und 7 die Halteelemente 5 oder Racks bei ihrem Vorschub geradewegs in die schon beschriebenen taschenförmigen Aufnahmen 15 dieses Transportmittels 16 einführen. Nach der Übergabe der Halteelemente 5 an den Auf- und Abwärtsförderer 16 und dessen Aufnahmen 15 sind die parallel zueinander orientierten und gemeinsam synchron miteinander in Vorschubrichtung bewegbaren Schlitten 6 und 7 wieder in ihre Ausgangslage zurückstellbar, so daß sie das nächste Paar von Halteelementen 5 mit einer oder mehreren Platten übernehmen und wieder heranführen können.

Ein derartiger Auf- und Abwärtsförderer 16 ist nicht nur in der schon erwähnten Vorwärmkammer 28, sondern gemäß Fig. 1 auch noch an drei weiteren Stellen, also innerhalb der gesamten Vorrichtung 1 im Ausführungsbeispiel insgesamt viermal vorhanden. Die diesbezüglichen nachfolgend beschriebenen Merkmale gelten dabei für all diese Förderer 16.

In den Figuren 19 und 20 erkennt man nun, daß dieser die Halteelemente 5 mit der oder den Platten 2 von den horizontal geführten Schlitten 6 und 7 übernehmende Förderer 16 ein aufwärtsführendes Trum 29 und ein über eine Umlenkrolle 30 wieder abwärtsführendes Trum 31 hat und daß die von dieser Trums getragenen taschen- oder U-förmigen Aufnahmen 15 in regelmäßigen Abständen über- bzw. nebeneinander angeordnet sind, in welche die Kupplungsenden 14 der Halteelemente 5 passen und gemäß Fig. 20 so tief einsteckbar sind, daß bei der Aufwärtsbewegung, der Schwenkbewegung im Bereich der oberen Umlenkung 30 und der anschließenden Abwärtsbewegung die beiden parallen, aus den Aufnahmen 15 mit den Greifbereichen oder der oder den Platten 2 vorstehenden Halteelemente 5 allein durch die Reibungskraft festsitzen. Spezielle zu öffnende und zu schliessende Klammern und dergleichen mechanisch aufwendige Teile werden also an dem Förderer 16 in vorteilhafter Weise vermieden, so dass auch das Uebergehen der Halteelemente 5 von den horizontal bewegten Schlitten 6 zu dem aufwärtsführenden Trum 29 sehr einfach und schnell vonstatten geht, wobei die Einsteckbewegung durch eine konische Ausbildung des äusseren Kupplungsendes 14 erleichtert wird.

Die U-förmige Aufnahme 15 für dasjenige Halteelement 5, welches auf einer festliegenden, in Querrichtung nicht verstellbaren Vorschubbahn vorwärtsbewegt wird, hat im Ausführungsbeispiel Seitenwände 15a etwa rechtwinklig zu den U-Schenkeln 15b dieser U-förmigen Aufnahme, deren lichter Abstand etwa der Breite des Kupplungsvorsprunges 14 des Halteelementes 5 entspricht, so dass die Aufnahme 15 des Auf- und Abwärtsförderers 16 in diesem Bereich als das Kupplungsende 14 des Halteelementes 5 allseits umschließende Kupplungstasche ausgebildet ist.

Von dieser seitlich geschlossenen Kupplungstasche ausgehend sind die Aufnahmen 15 über ihre gesamte seitliche Erstreckung U-förmig und mit gleichbleibendem Querschnitt ausgebildet, so daß das zweite Halteelement 5 in beliebigem Abstand von dem in die Tasche eingreifenden Halteelement 5 an seiner Ober- und Unterseite umgriffen wird. Somit erfolgt auch an diesen Aufnahmen 15 des Förderers 16 eine Berücksichtigung der Tatsache, daß zwei Halteelemente 5 parallel zueinander vorgesehen sind, deren eines immer auf einer gleichen und festliegenden Förderbahn herangeführt wird, während das andere aufgrund unterschiedlicher Amessungen der Platten in unterschiedlichen parallelen Abständen dazu zu liegen kommen kann. Somit sind die Aufnahmen 15 nicht nur bezüglich ihres Querschnittes an die Kupplungsenden 14 der Halteelemente 5 angepaßt, sondern auch an die Tatsache, daß hier jeweils zwei Halteelemente 5 Platten 2 unterschiedlicher Breite heranführen können und mit den Platten beim Umladen auf den Förderer 16 verbunden bleiben sollen.

In Fig. 19 erkennt man, daß das aufwärtsführende Trum und das abwärtsführende Trum 31 des Förderers 16 jeweils zur Vertikalen unter einem spitzen Winkel derart geneigt sind, daß die beiden Trums in dem oberen Bereich des Förderers 16 einen geringeren Abstand zueinander als im unteren Bereich haben. Dies wird dadurch erreicht, daß die obere Umlenkrolle oder -walze 30 des Förderers 16 einen kleineren Durchmesser als die untere Umlenkung 32 hat und die beiden Trums symmetrisch zu einer vertikalen Ebene durch die Achsen der beiden Umlenkungen 30 und 32 angeordnet sind.

Dabei entspricht der Winkel, unter welchem die Trums 29 und 31 zu einer Vertikalen angeordnet sind, etwa dem Verschwenk winkel, um welchen die Halteelemente 5 unter der Wirkung der Schwerkraft und unter Berücksichtigung des Kupplungsspieles in ihrem einseitigen Einspannbereich gegenüber dem aufwärtsführenden Trum 29 bzw. dem abwärtsführenden Trum 31 verschwenkt werden, um an dem Förderer 16 jeweils etwa horizontal abzustehen, damit eine frische Lackschicht od. dgl. nicht teilweise ablaufen kann. Statt also sehr genaue Passungen und Toleranzen anzustreben oder aufwendige Klammern und Unterstützungen vorzusehen, um die Halteelemmente 5 an dem Förderer 16 jeweils genau horizontal zu halten, damit frischer Lack oder Kunststoff nicht verlaufen kann, wird stattdessen mit relativ großen Steck-Toleranzen gearbeitet, die auch das Übergeben der Halteelemente 5 von einem zum anderen Fördermittel erleichtern, aber in ungewöhnlicher Weise eine Schrägstellung der beiden Trums zum Ausgleich dieses Spieles vorgesehen. Dieser Maßnahme kommt deshalb in diesem Zusammenhang eine ganz besondere Bedeutung zu , weil durch diesen zunächst nach oben und dann wieder nach unten transportierenden Förderer 16 ein Teil der Transportstrecke der Transportvorrichtung 1 etwa senkrecht zur übergeordneten Vorwärtsbewegung verläuft, wodurch die raumliche Ausdehnung der gesamten Vorrichtung 1 bei einer ausreichend langen Gesamttransportstrecke kleingehalten werden kann. So kann beispielsweise während dieser Auf- und Abwärtsförderung eine Vortrocknung, später eine erste Trocknung einer frischen Lackschicht und schliesslich eine ausreichend lange Trocknung durchgeführt werden, bei kontinuierlichem Weiterbewegen der Halteelemente 5 mit den von Ihnen erfassten Platten 2.

Am unteren Endbereich des abwärtsführenden Trums 31 des Förderers 16 ist wiederum eine horizontale Führungsbahn mit Schlitten 6 und 7 od.dgl. zur Übernahme der Halteelemente 5 mit Platten 2 vorgesehen, die gemäß Fig. 1 zu einer ersten Auftragvorrichtung 33 für Schutz- oder Lötstopp-Lack oder -Kunststoff führt, innerhalb welcher die nach oben weisende Seite der jeweiligen Platte 2 mit diesem Lack oder Kunststoff beschichtet wird. In nicht näher dargestellter Weise kann dabei in dieser Auftragvorrichtung 33 ein Lackbegrenzer vorgesehen sein, der von optoelektronischen Fühlern, gegebenenfalls denen am Einlauf 19 in die Vorrichtung 1 angesteuert ist und einen Lackauftrag auf die Halteelemente 5 und die daran befindlichen Greifer 3 verhindert.

Die horizontale Führungsbahn führt gemäß Fig. 1 durch diese Auftragvorrichtung 33 hindurch in eine Trockenkammer 34, in welcher - wie schon angedeutet - ein Auf- und Abwärtsförderer 16 entsprechend dem in der Vorwärmkammer 28 angeordnet ist, wobei die Vorschubgeschwindigkeit und die Höhe dieses Förderers 16 so gewählt sind, daß die auf der Oberseite der Platten 2 befindliche Lack-oder Kunststoffschicht während des Transportes nach oben soweit trockenbar ist, daß sie beim Umwenden und Abwärtsfördern nicht mehr verläuft.

Im unteren Übergabebereich des abwärtsführenden Trums 31 des Förderers 16 der Trockenkammer 34 schließt sich eine weitere horizontale Führungsbahn mit Schlitten 6 und 7 an und die abwärtsgeförderten Halteelemente 5 sind dort mit den Schlitten 6 und 7 kuppelbar und in eine weitere Auftragvorrichtung 33 förderbar, die der ersten Auftragvorrichtung 33 zweckmäßigerweise entspricht und nun die in dem Förderer 16 der ersten Trockenkammer 34 in vorteilhafter Weise von unten nach oben gekehrte Plattenseite beschichten kann. Dabei erweist sich dieser nach oben und unten fördernde, somit wenig Platz benötigende Förderer 16 insofern zusätzlich als vorteilhaft, als er gleichzeitig zum Wenden der Platten 2 dienen kann, wobei diese Wendung der Platten wiederum über die Halteelemente 5 erfolgt.

An die zweite Auftragvorrichtung 33 schließt sich wenigstens eine weitere Trockenkammer 34 mit zwei Auf- und Abwärtsförderer 16 an und hinter dieser ist dann eine Auslaufbahn 35 angeordnet. Im Ausführungsbeispiel werden somit vom Eintritt 19 bis zu dieser Auslaufbahn 35 die Platten insgesamt viermal gewendet, haben also wieder ihre Ausgangslage, sind nun aber beschichtet und getrocknet und dabei verschiedenen Handlings-Vorgängen unterzogen worden, ohne ein einziges Mal die sie erfassenden Halteelemente 5 verlassen zu müssen. Stattdessen sind diese gegen solche Umladvorgänge unempfindlichen Halteelemente 5 bewegt, übergeben, gewendet und vorgeschoben worden. Somit ergeben sich beschichtete Platten mit höchster Oberflächengüte, wobei in vorteilhafter Weise praktisch keine Ausschußrate mehr vorhanden ist.

An der Auslaufbahn 35 können Betätigungsvorrichtungen 18 zum Öffnen der Greifer 3 analog denen an der Einführbahn und Querförderer zum Erfassen und seitlichen Abführen der Halteelemente 5 vorgesehen sein. Seitlich des Auslaufbereiches können dann außerdem Fördermittel 35a zum Erfassen und Rückführen der Halteelemente zu den Liften 21 am Einlauf 19 in die Vorrichtung 1 angeordnet sein.

Diese sowohl im Anfangs- als auch im Endbereich der Transportvorrichtung 1 befindlichen Betätigungsvorrichtungen 18 und ihr Funktionsablauf ist in den Figuren 8 bis 18 Schritt für Schritt dargestellt und verläuft folgendermaßen:

Nachdem eine Leiterplatte 2 auf der Leiterplatten-Vorerkennung gemäss den Figuren 4 bis 7 gerichtet und bezüglich der Breite grob erkannt ist, kommen die Racks oder Halteelemente 5 vom Lift 21 und werden auf den Zahnriemenförderer 22 abgelegt und von dort gegen einen Anschlag 36 gefördert (Fig. 10).

Ein vor allem in Fig. 11 erkennbarer Greiferkopf 37, der gemäß der oberen Darstellung in Fig. 11 zunächst geöffnet ist, wird nun gemäß den Pfeilen Pf 1 geschlossen und erfaßt und zentriert die Halteelemente 5. Gemäß Fig. 12 hebt sodann dieser Greiferkopf 37 die Halteelemente 5 an und fährt gemäß dem Pfeil Pf 2 in Fig. 12 bis auf die vorerkannte Breite der jeweiligen Platte 2 zusammen.

Nunmehr wird der Greiferkopf 37 gemäß Fig. 13 in Richtung der Pfeile Pf 3 abgesenkt und legt die Halteelemente 5 auf die Schlitten 6 und 7.

Durch eine entsprechende Abwärtsbewegung der an den Greiferköpfen 37 befindlichen Betätigungsvorrichtungen 18 gemäß den gekrümmten Pfeilen Pf 4 in Fig. 14 werden nun die wippenartigen verschwenkbaren oberen Klemmbacken 9 der Greifer 3 der Halteelemente 5 geöffnet.

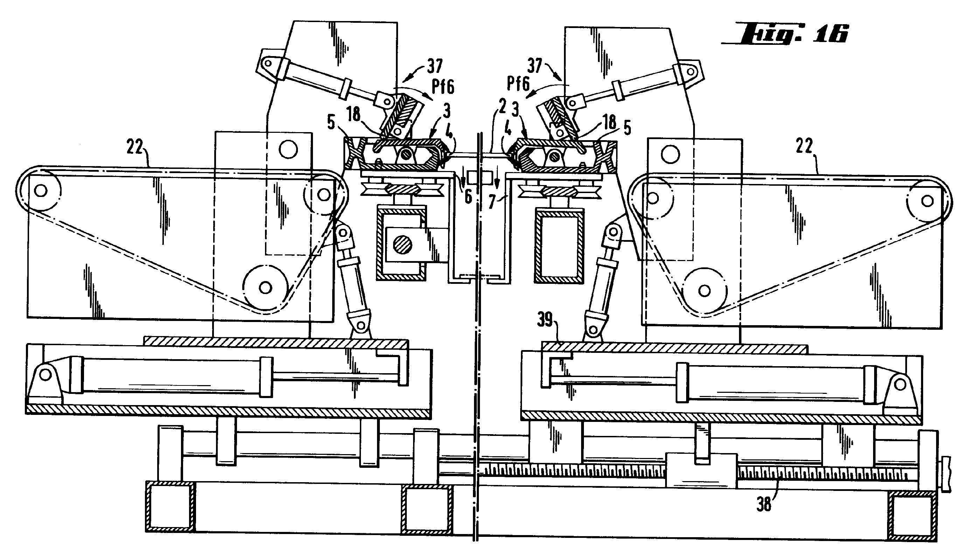

Über einen Spindelantrieb 38 wird nunmehr gemäß Fig. 15 der den einen Greiferkopf 37 tragende Querschlitten 39 in Richtung des Pfeiles Pf 5 weiterverschoben, bis der Abstand der beiden Halteelemente 5 und ihrer Greifer 3 der endgültigen Leiterplattenbreite entspricht.

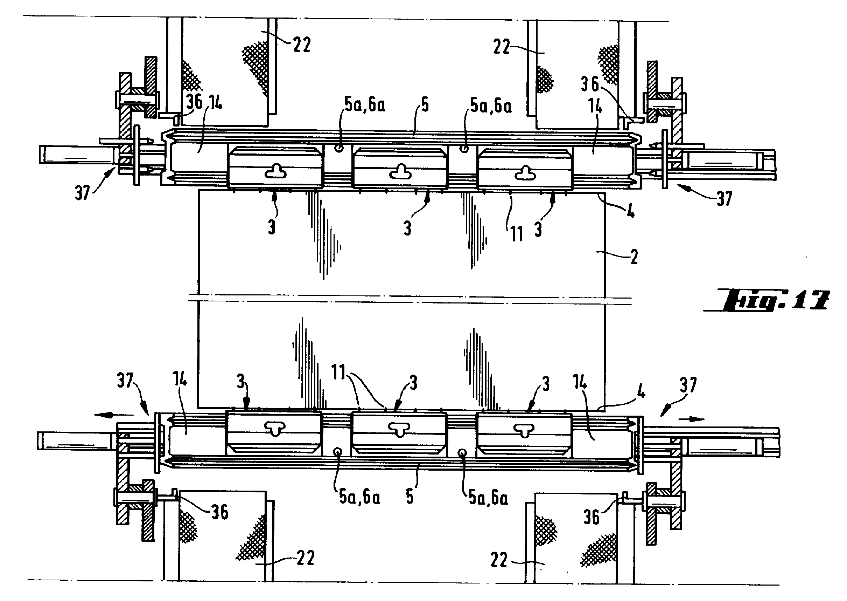

Gemäß Fig. 16 werden nun entsprechend den Pfeilen Pf 6 die Betätigungselemente 18 wieder von den Greifen 3 abgehoben, so daß sich die Greifer 3 aufgrund der Federn 8 schließen und also die Längsränder der Platte 2 einklemmen.

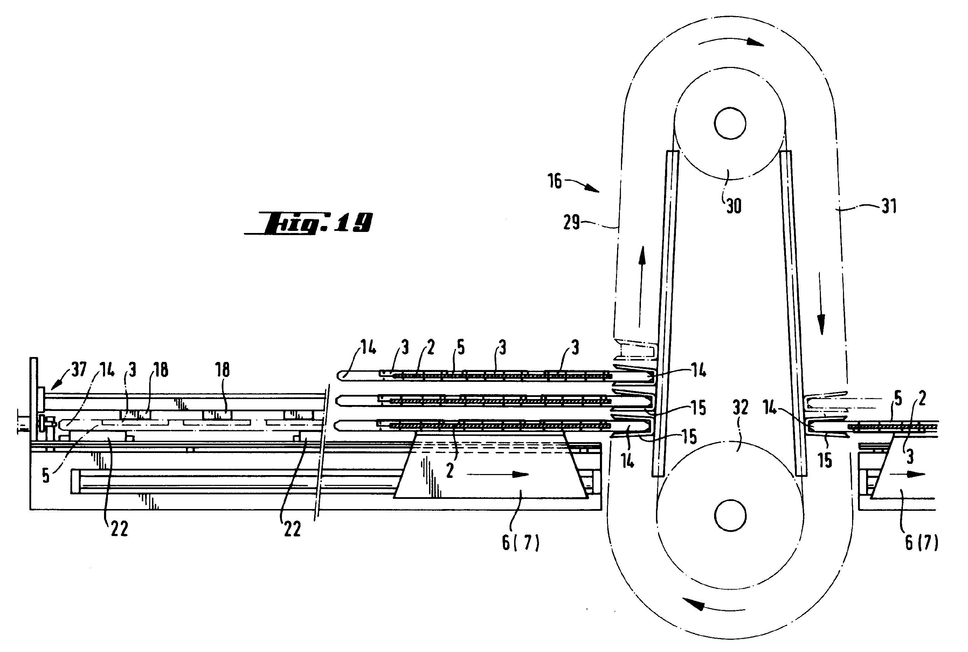

Gemäß Fig. 17 werden sodann die Greiferköpfe 37 geöffnet und gemäß Fig. 18 abgehoben und entsprechend den Pfeilen Pf 7 aus dem Bereich der Halteelemente 5 zurückverschoben.

Sodann kann gemäß Fig. 19 mit Hilfe der Schlitten 6 und 7 das eine Leiterplatte 2 erfassende Paar von Halteelementen 5 zu dem Förderer 16 transportiert werden, wobei dieser im Takt der ankommenden Halteelemente 5 die jeweils erfassten Halteelemente nach oben befördert. Dieser taktweise Transport der Halteelemente 5 und der Leiterplatten 2 innerhalb dieses paternosterartigen Förderers 16 wird bis zur Übergabe auf den sich anschließenden horizontalen Förderer beibehalten, der, wie schon beschrieben, zu einer ersten Auftragvorrichtung 33 für den Schutzlack oder Kunststoff führt.

Auch der Förderer 16 hinter dieser Auftragvorrichtung 33 taktet die Leiterplatte hoch, während sie einer Wärmebehandlung unterzogen wird, wendet sie und bringt sie zu dem nächsten horizontalen Förderer, der durch die zweite Auftragvorrichtung oder Gießmaschine führt und die nun nach oben gewendete Plattenseite beschichtet. Im sich anschließenden Paternoster werden die Leiterplatten wieder taktweise befördert und einer Wärmebehandlung unterzogen.

Die hinter den Trockenkammern befindlichen Handlingsgeräte arbeiten beim Öffnen der Halteelemente, deren Auseinanderführen und dem Entnehmen der fertigen Platte 2 in umgekehrter Reihenfolge, wie dies vorstehend anhand der Figuren 8 bis 18 erläutert wurde.

Die am Ende wieder freien und vereinzelten Halteelemente 5 können sofort zurückbefördert werden, um für die Übernahme weiterer Platten 2 benutzt zu werden. Insgesamt ergibt sich somit eine Transportvorrichtung 1, mit der auf engem Raum Leiterplatten erfaßt und beschichtet werden können, ohne daß eine Gefahr für die Empfindliche Oberfläche dieser Platten besteht, da die Halteelemente 5 für diese Platten 2 mit den Platten ständig verbunden bleiben, selbst wenn innerhalb der Transportvorrichtung 1 das jeweilige Vorschubmittel und die Vorschubrichtung gewechselt werden.

Dieses Prinzip, das Halteelement für die jeweilige Platte von dem Fördermittel unabhängig und umladbar zu machen und dafür entsprechende Kupplungsvorsprünge und Kupplungsmittel am Halteelement und den Fördermitteln vorzusehen, kann selbstverständlich auch bei anderen Vorrichtungen zum Handhaben und Bearbeiten plattenförmiger Werkstücke angewendet werden.

Das Handling der Platten 2 wird somit praktisch auf ihr Halteelemente 5 verlagert und damit die von diesem Handling ausgehende Gefahr von den Platten 2 ferngehalten.

## Patentansprüche

1. Tansportverfahren für Platten (2) oder plattenförmige Werkstücke mit einer Vorrichtung (1), die Vorschubmittel für den Transport der Platten (2) und Greifer (3) oder Klammern zum Erfassen der Plattenränder (4) während des Transportes und des Vorschubes der Platten (2) zu und durch Bearbeitungsstationen aufweist, wobei jeweils mindestens ein Greifer (3) oder eine Klammer an einem mit den Transport- oder Vorschubmitteln der Vorrichtung (1) lösbar kuppelbaren Halteelement (5) angebracht ist, und jeweils mindestens ein Halteelement (5) über seine(n) Greifer (3) mit einer Platte verbunden ist, dadurch gekennzeichnet, dass die Halteelemente (5) während des gesamten Transportes der Platten (2) durch die Bearbeitungsstationen mit den Platten verbunden sind und an den Uebergängen von einem Vorschubmittel zu einem anderen oder von einer Bearbeitungsstation zur anderen zusammen mit den von ihnen gehaltenen Platten (2) umgesetzt oder umgeladen werden.

2. Verfahren nach Anspruch 1, dadurch gekennzeichnet, daß zwei Halteelemente (5) mit je wenigstens einem Greifer (3) für die beiden in Vorschubrichtung orientierten Längsränder (4) einer Platte (2) vorgesehen sind, die beim Erfassen der Platte (2) auf deren Gesamtbreite eingestellt und danach an entsprechend zugestellte Transport- und/oder Vorschubmittel angekuppelt werden.

3. Verfahren nach Anspruch 1 oder 2, dadurch gekennzeichnet, dass das Vorschubmittel für das Halteelement (5) des einen Plattenrandes (4) innerhalb der Transportvorrichtung (1) entlang einer festshstehenen und festbleibenden Bahn und Orientierung geführt wird und dass das zweite synchron antreibbare Vorschubmittel für das zweite Halteelement (5) jeweils auf die Breite der zu bearbeitenden Platte (2) in seitlicher Richtung eingestellt wird.

4. Verfahren nach einem der Ansprüche 1 bis 3, dadurch gekennzeichnet, dass die Klammer oder der Greifer (3) an dem Halteelement (5) zwei relativ zueinander bewegbare und gegen eine Rückstellkraft voneinander wegspreizbare Backen (9, 10) hat, deren eine (10) unbeweglich mit dem Gehäuse (10a) des Halteelementes (5) verbunden ist oder zu diesem gehört, während die andere Backe (9) auf- und zuschwenkbar ist.

5. Verfahren nach Anspruch 4, dadurch gekennzeichnet, dass die Backen (9, 10) jedes Greifers (3) des Halteelementes (5) zum Erfassen eines Randes (4) einer Platte (2) jeweils wenigstens zwei in Längsrichtung des Plattenrandes (4) mit Abstand nebeneinander angeordnete, gegen die Plattenoberflächen gerichtete, vorzugsweise spitze Vorsprünge (11) haben, wobei einander entsprechende Vorsprünge (11) der beiden Backen mit ihren Spitzen (12) einander jeweils etwa gegenüberliegen.

6. Verfahren nach Anspruch 5, dadurch gekennzeichnet, dass die gegenüber der feststehenden Backe (10) hochschwenkbare Gegenbacke (9) eine gerundete Stirnseite (9a) hat, deren Krümmungsradius dem Schwenkradius dieser Stirnseite um die Schwenkachse (9b) dieser Klemmbacke (9) entspricht, und dass diese gekrümmte Stirnseite (9a) über eine analog gekrümmte Stirnseite (13) der feststehenden Backe (10) greift und die Vorsprünge (11) überragt.

7. Verfahren nach einem der Ansprüche 4 bis 6, dadurch gekennzeichnet, daß die schwenkbare Klemmbacke (9) des Greifers (3) an dem Halteelement (5) auf der in dessen Längserstreckung orientierten Schwenkachse (9b) wippenartig gelagert ist und der dem Backenteil mit den Vorsprüngen (11) an der Achse(9b) gegenüberliegende Überstand (17) als Betätigungsbereich zum Zusammenwirken mit einem ihn von oben her beaufschlagenden Betätigungselement (18) für das Hochschwenken der Schwenkbacke (9) gegen die Rückstellkraft vorgesehen ist.

8. Verfahren nach einem der Ansprüche 1 bis 7, dadurch gekennzeichnet, daß an einem Halteelement (5) wenigstens zwei Greifer (3) in Vorschubrichtung und Richtung der Längserstreckung des Halteelementes (5) hintereinander angeordnet werden, die gemeinsam eine große Platte (2) oder jede eine kleine Einzelplatte erfassen.

9. Verfahren nach einem der Ansprüche 1 bis 8, dadurch gekennzeichnet, dass wenigstens eines der beiden Enden, vorzugsweise beide Enden des Halteelementes (5) als Kupplungsenden (14) über den mit Greifern (3) bestückten Bereich in Längsrichtung des Halteelementes (5) vorstehen.

10. Verfahren nach einem der Ansprüche 1 bis 9, dadurch gekennzeichnet, daß die Halteelemente (5) im Zuführbereich (19) der Platten (2) in die Vorrichtung (1), von vorzugsweise seitlich der Vorschubrichtung der Platten (2) angeordneten Liften (21) und unterhalb der Lifte (21) quer zur Vorschubrichtung der Platten (2) angeordneten Fördermitteln, vorzugsweise schrittweise bewegbaren Förderbändern (22) zum Zuführen jeweils eines einzelnen Halteelementes von der Seite her auf die Plattenlangsränder zubewegt werden.

11. Verfahren nach einem der Ansprüche 1 bis 10, dadurch gekennzeichnet, daß im Bereich der Zuführbahn (20) für eine einzelne Platte (2) in die Vorrichtung (1) hinein durch deren Abmessungen beaufschlagte Fühler, vorzugsweise optoelektronische Fühler, insbesondere Lichtschranken vorgesehen werden, die den Antrieb für die Zuführung der Halteelemente (5) und die Betätigungsvorrichtung (18) zum Öffnen der Greifer (3) ansteuern.

12. Verfahren nach einem der Ansprüche 1 bis 11, dadurch gekennzeichnet, dass die Vorschubmittel für die Halteelemente (5) als Schlitten (6, 7) ausgebildet sind, an welchen die Halteelemente (5) lösbar angekuppelt werden.

13. Verfahren nach Anspruch 12, dadurch gekennzeichnet, dass der Schlitten (7) für das Halteelement (5) für den einen Längsrand (4) der Platte (2) mit seinem Vorschubantrieb quer zur Vorschubrichtung verstellt wird, wobei der Verstellantrieb durch einen oder mehrere der optoelektronischen Fühler und Anschläge angesteuert wird.

14. Verfahren nach Anspruch 12 oder 13, dadurch gekennzeichnet, dass die Unterseite des Halteelementes (5) vorzugsweise flach und eben ausgebildet wird und einer entsprechend ausgebildeten Oberseite der Vorschubschlitten (6, 7) angepasst wird und dass diese einander berührenden Flächen die Kupplungsmittel für die lösbare Kupplung zwischen Schlitten und Halteelement aufweisen.

15. Verfahren nach Anspruch 14, dadurch gekennzeichnet, dass als Kupplungsmittel Lochungen (5a) in dem einen Teil und in diese passende Vorsprünge, Stifte (6a) in dem anderen Teil vorgesehen werden.

16. Verfahren nach Anspruch 15, dadurch gekennzeichnet, dass die Kupplungslochung oder mehrere Kupplungslochungen (5a) an dem Halteelement (5) und der oder die Kupplungsstife (6a) oder -vorsprünge an der Oberseite des Vorschub-Schlittens (6, 7) angeordnet werden.

17. Verfahren nach Anspruch 15 oder 16, dadurch gekennzeichnet, dass der Kupplungsvorsprung als Indexbolzen mit einer Passung in die Kupplungsöffnung eingepasst wird und vorzugsweise ein sich verjüngendes freies Ende zur Zentrierung beim Einführen in die Kupplungsöffnung hat.

18. Verfahren nach einem der Ansprüche 9 bis 17, dadurch gekennzeichnet, daß das in Vorschubrichtung weisende Kupplungsende (14) des Halteelementes (5) als Steckkupplung zur lösbaren Verbindung mit dem auf- und abwärtsgerichteten Förderer (16) innerhalb einer Vorwärmkammer (28) den Schlitten (6, 7) in Vorschubrichtung überragt.

19. Verfahren nach einem der Ansprüche 12 bis 18, dadurch gekennzeichnet, daß die parallel zueinander orientierten und gemeinsam synchron miteinander in Vorschubrichtung bewegbaren Schlitten (6, 7) nach der Übergabe der Halteelemente (5) an den Auf- und Abwärtsförderer (16) in ihre Ausgangslage zurückgestellt werden.

20. Verfahren nach einem der Ansprüche 12 bis 19, dadurch gekennzeichnet, dass der die Halteelemente (5) mit der oder den Platten (2) von den horizontal geführten Schlitten (6, 7) übernehmende Förderer (16) ein aufwärtsführendes Trum (29) und ein über eine Umlenkrolle (30) wieder abwärtsführendes Trum (31) hat und dass die von diesen Trums getragenen taschen- oder U-förmigen Aufnahmen (15) in regelmässigen Abständen über- bzw. nebeneinander angeordnet sind, in welche die Kupplungsenden (14) der Halteelemente (5) passen und eingesteckt werden, so dass bei der Aufwärtsbewegung, der Schwenkbewegung im Bereich der oberen Umlenkung (30) und der anschliessenden Abwärtsbewegung die beiden parallelen Halteelemente (5) durch Reibungskraft allein festsitzen.

21. Verfahren nach Anspruch 20, dadurch gekennzeichnet, dass die U-förmige Aufnahme (15) für dasjenige Halteelement (5), welches auf einer festliegenden, nicht verstellbaren Vorschubbahn vorwärtsbewegt wird, Seitenwände (15a) etwa rechtwinklig zu den U-Schenkeln (15b) der U-förmigen Aufnahme hat, deren lichter Abstand etwa der Breite des Kupplungsvorsprunges (14) des Halteelementes (5) entspricht, so dass die Aufnahme (15) des Auf- und Abwärtsförderers (16) in diesem Bereich als das Kupplungsende (14) des Halteelementes (5) allseits umschliessende Kupplungstasche ausgebildet ist.

22. Verfahren nach Anspruch 21, dadurch gekennzeichnet, dass die Aufnahmen an jedem Auf- und Abwärtsförderer von den geschlossenen Kupplungstaschen ausgehend über die gesamte seitliche Erstreckung als U-förmige Aufnahme gleichbleibenden Querschnittes ausgebildet sind und das zweite Halteelement (5) in beliebigem Abstand von dem in die Tasche eingreifenden ersten Halteelement an seiner Ober- und Unterseite umgreifen.

23. Verfahren nach einem der Ansprüche 20 bis 22, dadurch gekennzeichnet, dass das aufwärtsführende Trum (29) und/ oder das abwärtsführende Trum (31) jedes Auf- und Abwärtsförderers (16) zur Vertikalen unter einem spitzen Winkel derart geneigt geführt werden, dass die beiden Trums in dem oberen Bereich des Förderers (16) einen geringeren Abstand zueinander als im unteren Bereich haben.

24. Verfahren nach einem der Ansprüche 20 bis 23, dadurch gekennzeichnet, daß die obere Umlenkrolle oder -walze (30) des Auf- und Abwärtsförderers (16) einen kleineren Durchmesser als die untere Umlenkung

EP 0 312 498 B1

(32) hat und die beiden Trums symmetrisch zu einer vertikalen Ebene durch die Achsen der beiden Umlenkungen (30, 32) angeordnet sind.

25. Verfahren nach Anspruch 23, dadurch gekennzeichnet, dass der Winkel, unter welchem die Trums (29, 31) zu einer Vertikalen angeordnet sind, etwa dem Verschwenkwinkel entspricht, um welchen die Halteelemente (5) unter der Wirkung der Schwerkraft und unter Berücksichtigung des Kupplungsspieles in ihrem Einspannbereich gegenüber dem aufwärtsführenden Trum (29) bzw, dem abwärtsführenden Trum (31) verschwenkt werden, und dass die Halteelemente (5) an dem Förderer jeweils etwa horizontal abstehen.

26. Verfahren nach einem der Ansprüche 20 bis 25, dadurch gekennzeichnet, dass am unteren Endbereich des abwärtsführenden Trums (31) des Förderers (16) eine horizontale Führungsbahn mit Schlitten (6, 7) zur Uebernahme der Halteelemente (5) mit den Platten (2) vorgesehen wird, die zu einer Auftragsvorrichtung (33) für härtbare flüssige Kunststoffmassen, insbesondere UV-härtbare Schutz- oder Lötstopp-Lacke führt, innerhalb welcher vorzugsweise die nach oben weisende Seite der Platte (2) mit diesem Lack beschichtet wird.

27. Verfahren nach Anspruch 26, dadurch gekennzeichnet, dass in der Auftragsvorrichtung (33) ein Lackbegrenzer vorgesehen ist, der von optoelektronischen Fühlern angesteuert wird und eine Verunreinigung der Halteelemente (5) und daran befindlichen Greifer (3) verhindert.

28. Verfahren nach Anspruch 26 oder 27, dadurch gekennzeichnet, daß die horizontale Führungsbahn durch die Auftragvorrichtung (33) hindurch in eine Trockenkammer (34) führt, in welcher ein Auf- und Abwärtsförderer (16) - entsprechend dem Auf- und Abwärtsförderer in der Vorwärmkammer (28) - angeordnet ist, wobei die Vorschubgeschwindigkeit und die Höhe dieses Förderers (16) so gewählt werden, daß die auf der Oberseite der Platten (2) befindliche Lack- oder Kunststoffschicht während des Transportes nach oben soweit getrocknet wird, daß sie beim Umwenden und Abwärtsfördern nicht mehr verläuft.

29. Verfahren nach einem der Ansprüche 26 bis 28, dadurch gekennzeichnet, daß im unteren Übergabebereich des abwärtsführenden Trums (31) des Förderers (16) der Trockenkammer (34) eine weitere horizontale Fürungsbahn mit Schlitten (6, 7) angeschlossen wird und die abwärtsgeförderten Halteelemente (5) an dort angeordneten Schlitten angekuppelt und in eine weitere Auftragvorrichtung (33) gefördert werden, die der ersten Aüftragvorrichtung (33) vorzugsweise entspricht.

30. Verfahren nach Anspruch 29, dadurch gekennzeichnet, dass sich an die zweite Auftragvorrichtung (33) wenigsstens eine weitere Trockenkammer (34) mit einem Auf- und Abwärtsförderer (16) anschliesst und hinter dieser oder wenigstens einer weiteren Trockenkammer (34) eine Auslaufbahn (35) angeordnet wird.

31. Verhahren nach Anspruch 30, dadurch gekennzeichnet, dass an der Auslaufbahn (35) Betätigungsvorrichtungen (18) zum Oeffnen der Greifer (3) analog denen an der Einführbahn und Querförderer zum Erfassen und seitlichen Abziehen der Halteelemente (5) vorgesehen werden.

32. Verfahren nach Anspruch 30 oder 31, dadurch gekennzeichnet, dass seitlich der Auslaufbahn (35) Fördermittel (35a) zum Erfassen und Rückführen der Halteelemente zu den Liften (21) am Einlauf (19) in die Vorrichtung (1) angeordnet werden.


**Claims**

1. A method of transporting boards (2) or workpieces in the form of boards by means of an apparatus (1) comprising advancing means for transporting the boards (2) and grippers (3) or clamps for gripping the board edges (4) during the transport and advancement of the boards (2) to and through processing stations, at least one gripper (3) or one clamp being provided on a holding element (5) which can be releasably coupled to the transporting or advancing means of the apparatus (1), and at least one holding element (5) being connected to a board by means of its gripper(s) (3), wherein the holding elements (5) are connected to the boards (2) during the entire transport of the boards through the processing stations and are transferred or reloaded, together with the boards (2) held by them, at the transitions from one advancing means to another or from one processing station to another.

2. A method according to claim 1, wherein two holding elements (5), each incorporating at least one gripper (3), are provided for the two longitudinal edges (4) of a board (2) which are oriented in the direction of advancement, which holding elements are adjusted to the overall width of the board (2) when the latter is seized and are then coupled to transporting and/or advancing means brought into corresponding positions.

3. A method according to claim 1 or 2, wherein the advancing means for the holding element (5) of the one board edge (4) are guided within the transport apparatus (1) along a path and in an orientation which are fixed and remain fixed and the second, synchronously drivable, advancing means for the second holding element (5) are adjusted in a lateral direction to the respective width of the board (2) to be processed.

4. A method according to any one of claims 1 to 3, wherein the clamp or the gripper (3) on the holding element (5) has two jaws (9, 10) or the like which can be moved relative to each other and can be spread apart

14

EP 0 312 498 B1

from each other against a restoring force, one of which jaws (10) is immovably connected to the housing (10a) of the holding element (5) or is integral with the latter, while the other jaw (9) can be pivoted open and closed.

5. A method according to claim 4, wherein for seizing an edge (4) of a board (2) the jaws (9, 10) of each gripper (3) of the holding element (5) have each at least two, preferably pointed, projections (11) which are arranged spaced apart from each other in the longitudinal direction of the board edge (4) and point towards the board surfaces, respectively corresponding projections (11) of the two jaws lying with their tips (12) approximately opposite each other.

6. A method according to claim 5, wherein the counter-jaw (9), which can be pivoted up with respect to the fixed jaw (10), has a rounded end face (9a), the radius of curvature of which corresponds to the pivoting radius of that end face about the pivot axis (9b) of that clamping jaw (9), and wherein that curved end face (9a) overlaps an analogously curved end face (13) of the fixed jaw (10) and extends beyond the projections (11).

7. A method according to any one of claims 4 to 6, wherein the pivoting clamping jaw (9) of the gripper (3) on the holding element (5) is mounted like a rocker on the pivot axis (9b) extending in the longitudinal direction of the holding element, and the overhang (17) lying on the opposite side of the axis (9b) from the jaw part with the projections (11) is provided as an actuating region for interaction with an actuating element (18), acting on it from above, for pivoting the pivoting jaw (9) upward against the restoring force.

8. A method according to any one of claims 1 to 7, wherein a plurality of, and at least two or three, grippers (3) are arranged on a holding element (5) one behind another in the direction of advancement and in the direction of the longitudinal extent of the holding element (5), which grippers together grip a large board (2) or each grip a small individual board.

9. A method according to any one of claims 1 to 8, wherein at least one of the two ends, and preferably both ends, of the holding element (5) project as coupling ends (14) beyond the region fitted with grippers (3), in the longitudinal direction of the holding element (5).

10. A method according to any one of claims 1 to 9, wherein the holding elements (5) are moved towards the longitudinal edges of the boards in the feed region (19) of the boards (2) into the apparatus (1) by lifts (21) preferably arranged laterally of the direction of advancement of the boards (2) and by conveying means, preferably conveyor belts (22) that are movable step by step or the like, which are arranged underneath the lifts (21) and transversely to the direction of advancement of the boards (2), for feeding an individual holding element from the side.

11. A method according to any one of claims 1 to 10, wherein, in the region of the feed track (20) for feeding an individual board (2) into the apparatus (1), there are provided sensors, preferably optoelectronic sensors, especially light barriers, which are controlled by the dimensions of the said board and activate the drive for the feeding of the holding elements (5) and the actuating device (18) for opening the grippers (3).

12. A method according to any one of claims 1 to 11, wherein the advancing means for the holding elements (5) are in the form of carriages (6, 7) or the like to which the holding elements (5) are releasably coupled.

13. A method according to claim 12, wherein the carriage (7) for the holding element (5) for the one longitudinal edge (4) of the board (2) is displaced together with its advancing drive transversely to the direction of advancement, the displacing drive being activated by one or more of the optoelectronic sensors and stops.

14. A method according to claim 12 or 13, wherein the lower side of the holding element (5) is preferably of flat and even design and is adapted to a correspondingly designed upper side of the advancing carriages (6, 7) and wherein these mutually contacting surfaces have the coupling means for effecting the releasable coupling between carriage and holding element.

15. A method according to claim 14, wherein perforations (5a) in the one part and projections, pins (6a) or the like, fitting in the latter, in the other part are provided as coupling means.

16. A method according to claim 15, wherein the coupling perforation or plurality of coupling perforations (5a) is arranged on the holding element (5) and the coupling pin(s) (6a) or projection(s) is(are) arranged on the upper side of the advancing carriage (6, 7).

17. A method according to claim 15 or 16, wherein the coupling projection is fitted into the coupling opening as an index bolt that fits and preferably has a tapering free end for centring during introduction into the coupling opening.

18. A method according to any one of claims 9 to 17, wherein the coupling end (14), pointing in the direction of advancement, of the holding element (5) projects beyond the carriage (6, 7) in the direction of advancement as a plug-in coupling for its releasable connection to the upwardly and downwardly directed conveyor (16) within a preheating chamber (28).

19. A method according to any one of claims 12 to 18, wherein the carriages (6, 7), which are oriented parallel to each other and can be moved synchronously with each other in the direction of advancement, are returned to their initial position after transfer of the holding elements (5) to the upward and downward conveyor (16).

20. A method according to any one of claims 12 to 19, wherein the conveyor (16) accepting the holding

15

elements (5) with the board or boards (2) from the horizontally guided carriages (6, 7) has an upwardly leading run (29) and a run (31) leading downwards again over a return roller (30) and wherein the pocket-shaped or U-shaped receptacles (15) carried by these runs are arranged at regular intervals one above another or one beside another, into which receptacles the coupling ends (14) of the holding elements (5) fit and are inserted such that, during the upward movement, the pivoting movement in the region of the upper return (30) and the subsequent downward movement, the two parallel holding elements (5) are seated firmly by frictional force alone.

21. A method according to claim 20, wherein the U-shaped receptacle (15) for that holding element (5) which is moved forwards on a fixed, non-adjustable advancing track has side walls (15a) approximately perpendicular to the U-legs (15b) of the U-shaped receptacle, the inside width of which corresponds approximately to the width of the coupling projection (14) of the holding element (5), so that the receptacle (15) of the upward and downward conveyor (16) is designed in that region as a coupling pocket surrounding the coupling end (14) of the holding element (5) on all sides.

22. A method according to claim 21, wherein, from the closed coupling pockets over the entire lateral extent, the receptacles on each upward and downward conveyor are designed as U-shaped receptacles of constant cross-section and clasp the second holding element (5) at its upper and lower side at any desired distance from the first holding element which engages in the pocket.

23. A method according to any one of claims 20 to 22, wherein the upwardly leading run (29) and/or the downwardly leading run (31) of each upward and downward conveyor (16) are/is guided inclined at a small angle to the vertical in such a manner that the two runs have a smaller distance from each other in the upper region of the conveyor (16) than in the lower region.

24. A method according to any one of claims 20 to 23, wherein the upper return roll or roller (30) of the upward and downward conveyor (16) has a smaller diameter than the lower return (32) and the two runs are arranged symmetrically about the vertical plane through the axes of the two returns (30, 32).

25. A method according to claim 23, wherein the angle at which the runs (29, 31) are arranged to the vertical corresponds approximately to the pivoting angle by which the holding elements (5) are pivoted with respect to the upwardly leading run (29) and the downwardly leading run (31) under the effect of gravity and in consideration of the coupling play in the region in which they are held, and the holding elements (5) on the conveyor project approximately horizontally in each case.

26. A method according to any one of claims 20 to 25, wherein, at the lower end region of the downwardly leading run (31) of the conveyor (16), a horizontal guide track with carriages (6, 7) or the like is provided for receiving the holding elements (5) with the boards (2), which guide track leads to an application device (33) for curable liquid plastics compositions, especially UV-curable protective or solder-resist lacquers, within which preferably the upwardly facing side of the board (2) is coated with that lacquer.

27. A method according to claim 26, wherein there is provided in the application device (33) a lacquer limiter which is activated by optoelectronic sensors and prevents contamination of the holding elements (5) and grippers (3) located thereon.

28. A method according to claim 26 or 27, wherein the horizontal guide track leads through the application device (33) into a drying chamber (34) in which an upward and downward conveyor (16), corresponding to the upward and downward conveyor in the preheating chamber (28), is arranged, the advancing speed and the height of that conveyor (16) being chosen such that the lacquer or plastics layer which is on the upper side of the boards (2) is dried during the upward transport to such an extent that it no longer runs when the board is turned over and conveyed downwards.

29. A method according to any one of claims 26 to 28, wherein, in the lower transfer region of the downwardly leading run (31) of the conveyor (16) of the drying chamber (34), a further horizontal guide track with carriages (6, 7) or the like is connected, and the downwardly conveyed holding elements (5) are coupled to carriages arranged there and conveyed into a further application device (33) preferably corresponding to the first application device (33).

30. A method according to claim 29, wherein the second application device (33) is followed by at least one further drying chamber (34) with an upward and downward conveyor (16) and, downstream thereof or of at least one further drying chamber (34), a delivery track (35) is arranged.

31. A method according to claim 30, wherein there are provided on the delivery track (35) actuating devices (18) for opening the grippers (3), analogous to those on the entry track, and transverse conveyors for seizing and laterally removing the holding elements (5).

32. A method according to claim 30 or 31, wherein conveying means (35a) for seizing and returning the holding elements to the lifts (21) at the entry (19) to the apparatus (1) are arranged laterally of the delivery track (35).

**Revendications**

1. Procédé de transport de plaques ou plaquettes (2) ou de pièces en forme de plaques ou plaquettes, au moyen d'un dispositif (1) qui présente des moyens d'avancement destinés au transport des plaques ou plaquettes (2), et des pinces (3) ou des agrafes servant à saisir les bords (4) des plaques ou plaquettes pendant le transport et l'avancement des plaques ou plaquettes (2) jusqu'à et à l'intérieur des postes de traitement, au moins une pièce (3) ou une agrafe étant disposée dans chaque cas sur un élément (5) de maintien susceptible d'être accouplé de façon libérable aux moyens de transport et d'avancement du dispositif, et au moins un élément (5) de maintien étant susceptible d'être relié à une plaque ou plaquette par l'intermédiaire de sa (ses) pince(s) (3), caractérisé en ce que les éléments (5) de maintien sont reliés aux plaques ou plaquettes pendant l'ensemble du transport des plaques ou plaquettes (2) dans les postes de traitement et ils sont déplacés ou transférés en même temps que les plaques ou plaquettes (2) qu'ils maintiennent lors des passages d'un moyen d'avancement à un autre ou d'un poste de traitement à un autre.

2. Procédé selon la revendication 1, caractérisé en ce que sont prévus deux éléments de maintien (5) comportant chacun au moins une pince (3) et destinés aux deux bords longitudinaux (4) d'une plaquette (2) orientés dans le sens d'avancement qui, lors de la saisie de la plaque ou plaquette (2) sont réglés sur la totalité de sa largeur et sont ensuite accouplés à des moyens de transport et/ou d'avancement mis à disposition de manière correspondante.

3. Procédé selon la revendication 1 ou 2, caractérisé en ce que l'un des moyens d'avancement destinés à l'élément de maintien (5) de l'un (4) des bords de la plaque ou plaquette est guidé à l'intérieur du dispositif (1) de transport le long d'une piste fixe et constante et avec une orientation fixe et constante, et en ce que le deuxième moyen d'avancement susceptible d'être entraîné en synchronisme, destiné au deuxième élément (5) de maintien, peut, dans chaque cas, être réglé dans le sens latéral sur la largeur de la plaque ou plaquette (2) qui doit être traitée.

4. Procédé selon l'une des revendications 1 à 3, caractérisé en ce que l'agrafe ou la pince (3) située sur l'élément de maintien (5) comporte deux mâchoires (9, 10) ou des éléments similaires, susceptibles d'être déplacées l'une par rapport à l'autre et d'être écartées l'une de l'autre à l'encontre d'une force de rappel, dont l'une (10) est reliée de façon fixe au corps (10a) de l'élément (5) de maintien ou appartient à celui-ci, tandis que l'autre mâchoire (9) peut être ouverte ou fermée par pivotement.

5. Procédé selon la revendication 4, caractérisé en ce que les mâchoires (9, 10) de chaque pince (3) de l'élément de maintien (5) comportent, dans chaque cas, en vue de saisir un bord (4) d'une plaque ou plaquette (2), au moins deux saillies (11), de préférence pointues, disposées à une certaine distance l'une de l'autre dans le sens longitudinal du bord (4) de la plaque ou plaquette, les saillies (11), correspondant entre elles, des deux mâchoires étant situées dans chaque cas de manière que leurs pointes (12) soient approximativement l'une en face de l'autre.

6. Procédé selon la revendication 5, caractérisé en ce que la contre-mâchoire (a), susceptible de pivoter largement par rapport à la mâchoire (10) fixe, comporte un côté frontal (9a) arrondi, dont le rayon de courbure correspond au rayon de pivotement de ce côté frontal sur l'axe (9b) de pivotement de cette mâchoire (9) de serrage, et en ce que ce côté frontal (9a) incurvé s'applique sur un côté frontal (13), doté d'une courbure analogue, de la mâchoire (10) fixe et dépasse en hauteur les saillies (11).

7. Procédé selon une des revendications 4 à 6, caractérisé en ce que la mâchoire (9) pivotante de serrage, faisant partie de la pince (3) située sur l'élément de maintien (5), est montée de façon basculante sur l'axe (9b) de pivotement orienté dans le sens longitudinal de celui-ci, et en ce que le porte-à-faux (17) situé près de l'axe (9b), en face de la partie de mâchoire comportant les saillies (11), est prévu en tant que zone d'actionnement dans le but de coopérer avec un élément d'actionnement (18) qui l'attaque à partir du haut, en vue du pivotement vers le haut de la mâchoire pivotante (9) à l'encontre de la force de rappel.

8. Procédé selon une des revendications 1 à 7, caractérisé en ce que, sur un élément de maintien (5), sont disposés plusieurs, au moins deux ou trois, pinces (3) l'une à la suite de l'autre dans le sens de l'avancement et dans le sens longitudinal de l'élément de maintien (5), lesquelles pinces saisissent ensemble une grande plaque ou plaquette (2), ou bien chacune une petite plaque ou plaquette individuelle.

9. Procédé selon une des revendications 1 à 8, caractérisé en ce que au moins une des deux extrémités, de préférence les deux extrémités, de l'élément de maintien (5) fait ou font saillie en tant qu'extrémité(s) d'accouplement (14), au-delà de la zone équipée de pinces (3), dans le sens longitudinal de l'élément de maintien (5).

10. Procédé selon une des revendications 1 à 9, caractérisé en ce que les éléments (5) de maintien sont déplacés dans la zone d'amenage (19) des plaques ou plaquettes (2) dans le dispositif (1) au moyen des éléments élévateurs (21) disposés de préférence latéralement par rapport au sens d'avancement des plaques ou plaquettes (2), et de moyens de transport, de préférence des bandes transporteuses (22) ou des éléments similaires disposés au-dessus des éléments élévateurs (21), transversalement au sens d'avancement des plaques ou plaquettes (2), bandes susceptibles d'être déplacées de préférence pas à pas en vue de l'amenage, dans chaque cas, d'un élément de maintien individuel, à partir du côté, jusque sur les bords longitudinaux des plaques ou plaquettes.

11. Procédé selon une des revendications 1 à 10, caractérisé en ce que l'on prévoit dans la zone de la piste d'amenage (20), dans le dispositif (1), destinée à une plaque ou plaquette individuelle, des capteurs sensibles à ses dimensions, de préférence des capteurs opto-électroniques, en particulier des relais photo-électriques, qui commandent l'entraînement de l'amenage des éléments de maintien (5) ainsi que le dispositif d'actionnement (18) destiné à l'ouverture des pinces (3).

12. Procédé selon une des revendications 1 à 11, caractérisé en ce que les moyens d'avancement destinés au éléments de maintien (5) sont conformés en chariots (6, 7) ou en des éléments similaires, sur lesquels les éléments (5) de maintien sont accouplés de façon libérable.

13. Procédé selon la revendication 12, caractérisé en ce que le chariot (7) destiné à l'élément de maintien (5), lui-même destiné à l'un (4) des bords longitudinaux de la plaque ou plaquette (2), est déplacé au moyen de son entraînement d'avancement transversalement à la direction d'avancement, l'entraînement de réglage étant commandé par un ou plusieurs des capteurs opto-électroniques et par des butées.

14. Procédé selon la revendication 12 ou 13, caractérisé en ce que le côté inférieur de l'élément de maintien (5) a de préférence une forme plate et parfaitement adaptée à un côté supérieur conformé de manière correspondante, du chariot (6, 7) d'avancement, et en ce que ces surfaces en contact l'une avec l'autre présentent les moyens d'accouplement destinés à l'accouplement libérable du chariot et de l'élément de maintien.

15. Procédé selon la revendication 14, caractérisé en ce que l'on prévoit, en tant que moyen d'accouplement, des perçages (5a) ménagés dans l'une des parties et, dans l'autre partie, des saillies, des tiges (6a) ou des éléments similaires, qui s'enfoncent de façon ajustée dans ces perçages.

16. Procédé selon la revendication 15, caractérisé en ce que le perçage d'accouplement ou l'ensemble des perçages d'accouplement (5a) est ou sont disposés sur l'élément (5) de maintien et en ce que la ou les tiges ou saillies d'accouplement (6a) sont disposées sur le côté supérieur du chariot (6, 7) d'avancement.

17. Procédé selon la revendication 15 ou 16, caractérisé en ce que la saillie d'accouplement est introduite de manière ajustée, en tant que tige d'indexation, dans l'ouverture d'accouplement et comporte de préférence une extrémité libre, qui se rétrécit et est destinée au centrage lors de l'introduction dans l'ouverture d'accouplement.

18. Procédé selon une des revendications 9 à 17, caractérisé en ce que l'extrémité d'accouplement (14), orientée dans le sens d'avancement, de l'élément (5) de maintien, dépasse en tant qu'accouplement par enfichage destiné à la liaison libérable avec le dispositif (16) de transport ascendant et descendant situé à l'intérieur d'une chambre de préchauffage (28), les chariots (6,7) dans le sens d'avancement.

19. Procédé selon une des revendications 12 à 18, caractérisé par le fait que les chariots (6, 7), orientés parallèlement l'un à l'autre et susceptibles d'être déplacés ensemble en synchronisme dans le sens de déplacement, sont ramenés dans leur position de départ après le transport des éléments (5) de maintien, sur le dispositif (16) de transport ascendant et descendant.

20. Procédé selon une des revendications 12 à 19, caractérisé en ce que le dispositif (16) de transport prenant en charge les éléments de maintien (5), avec la ou les plaquettes (5) à partir des chariots guidés horizontalement, comporte une partie ascendante (29) et une partie (31) qui redescend après le passage sur un rouleau de renvoi (30), et en ce que les réceptacles (15) en forme de poche ou de U, portés par ces parties, sont disposés les uns au-dessus des autres, ou les uns à côté des autres à intervalles réguliers, et en ce que les extrémités (14) d'accouplement des éléments de maintien (15), y correspondent bien et s'y engagent ou y sont enfichées de façon ajustée, si bien que lors du mouvement ascendant, du mouvement pivotant dans la zone du renvoi (30) supérieur et du mouvement descendant qui suit, les deux éléments (5) de maintien, parallèles, sont fixés solidement par la seule force de frottement.

21. Procédé selon la revendication 20, caractérisé en ce que le réceptacle (15) en forme de U, destiné à recevoir l'élément (5) de maintien qui est déplacé vers l'avant sur un trajet d'avancement fixe, non réglable, comporte des parois latérales (15a) approximativement perpendiculaires aux branches du U (15b) du réceptacle en forme de U, dont la distance libre ou dégagée correspond approximativement à la largeur de la saillie (14) d'accouplement de l'élément (5) de maintien, si bien que le réceptacle (15 du dispositif (16) de transport ascendant et descendant est, dans cette zone, conformé en une poche ou un creux d'accouplement entourant de toutes parts l'extrémité d'accouplement de l'élément de maintien (5).

22. Procédé selon la revendication 21, caractérisé en ce que les réceptacles de chaque dispositif de transport ascendant et descendant sont conformés à partir des poches ou creux d'accouplement fermés, pour constituer des réceptacles en forme de U de section transversale constante sur l'ensemble de l'étendue latérale et en ce qu'ils entourent le deuxième élément de maintien (5) sur son côté supérieur et sur son côté inférieur à une distance choisie à volonté par rapport au premier élément de maintien pénétrant dans la poche ou le creux.

23. Procédé selon une des revendications 20 à 22, caractérisé en ce que le brin ou partie ascendante (29) et/ou le brin ou partie descendante (31) de chaque dispositif (16) est ou sont guidés en présentant une inclinaison à angle aigu par rapport à la verticale,de façon telle que les deux brins sont, dans la partie supérieure du dispositif (16) de transport, moins éloignés l'un de l'autre que dans la partie inférieure.

24. Procédé selon une des revendications 20 à 23, caractérisé en ce que le rouleau ou cylindre de renvoi (30) supérieur du dispositif (16) a un plus faible diamètre que celui du renvoi inférieur (32) et en ce que les deux brins sont disposés symétriquement par rapport à un plan vertical passant par les axes des deux renvois (30, 32).

25. Procédé selon la revendication 23, caractérisé en ce que l'angle que forment les brins (29, 31) avec une verticale correspond approximativement à l'angle de pivotement dont pivotent les éléments de maintien (5) sous l'effet de la force de gravité et en tenant compte du jeu d'accouplement dans leur zone de serrage par rapport au brin ou partie ascendante (29) ou au brin ou partie descendante (31), et en ce que les éléments de maintien (5) font saillie dans chaque cas approximativement horizontalement.

26. Procédé selon une des revendications 20 à 25, caractérisé en ce que,dans la zone d'extrémité inférieure du brin ou de la partie descendante (31) du dispositif (16) de transport est prévue une piste horizontale de guidage comportant des chariots (6, 7) ou des éléments similaires, destinés à prendre en charge les éléments de maintien (5) comportant les plaques ou plaquettes (2), laquelle piste conduit à un dispositif (33) d'application, à titre de revêtement, de masses de matière plastique liquides, en particulier des vernis de protection ou anti-soudure, susceptibles d'être durcis aux ultraviolets, dispositif à l'intérieur duquel la face de la plaque ou de la plaquette (2) orientée vers le haut, est revêtue au moyen de ce vernis.

27. Procédé selon la revendication 26, caractérisé en ce que l'on prévoit, dans le dispositif (33) de revêtement, un élément de limitation de l'application de vernis, qui est commandé par des capteurs opto-électroniques et qui empêche une souillure des éléments (5) de maintien et des pinces (3) qui se trouvent sur ceux-ci.

28. Procédé selon la revendication 26 ou 27, caractérisé en ce que la piste horizontale de guidage traverse le dispositif (33) de revêtement pour parvenir dans une chambre (34) de séchage, dans laquelle est disposé un dispositif de transport ascendant et descendant (16) correspondant au dispositif de transport ascendant et descendant de la chambre (28) de préchauffage, la vitesse d'avancement et la hauteur de ce dispositif de transport (16) étant choisies de façon telle que la couche de vernis ou de matière plastique qui se trouve sur la face supérieure des plaques ou plaquettes (2) soit suffisamment séchée pendant le transport vers le haut pour qu'elle ne coule pas lors du retournement et lors du transport vers le bas.

29. Procédé selon une des revendications 26 à 28, caractérisé en ce que, dans la zone de transport inférieur du brin descendant (31) du dispositif de transport (16) de la chambre (34) de séchage est raccordée une autre piste horizontale de guidage comportant des chariots (6, 7) ou des éléments similaires, et en ce que les éléments de maintien (5) transportés vers le bas sont accouplés à des chariots qui sont disposés à cet endroit et peuvent être transportés dans un autre dispositif (33) de revêtement, qui correspond de préférence au premier dispositif (33) de revêtement.

30. Procédé selon la revendication 29, caractérisé en ce qu'au moins une autre chambre (34) de séchage comportant un dispositif de transport ascendant et descendant (16) est raccordée au deuxième dispositif (33) de revêtement, et en ce qu'en aval de ces autres chambres (34) de séchage, ou au moins de cette autre chambre (34) de séchage, est disposée une piste (35) d'évacuation ou de sortie.

31. Procédé selon la revendication 30, caractérisé en ce que l'on prévoit sur la piste (35) d'évacuation des dispositifs d'actionnement (18) destinés à l'ouverture des pinces (3) analogues à ceux situés sur la piste d'entrée et en ce que sont prévus des dispositifs de transport transversal, destinés à saisir et à retirer latéralement les éléments de maintien (5).

32. Procédé selon la revendication 30 ou 31, caractérisé en ce que sur le côté de la piste (35) d'évacuation sont prévus des moyens de transport (35a) destinés à saisir et à ramener les éléments de maintien jusqu'à des éléments élévateurs (21) situés à l'entrée (19) du dispositif (1).

Fig. 1

*Fig. 2*

*Fig. 3*

Fig. 4

Fig. 5

## Fig. 6

## Fig. 7

Fig. 8

Fig. 9

Fig. 10

Fig. 11

Fig. 12

28

*Fig. 13*

Fig. 14

Fig: 15

Fig. 16

Fig. 17

Fig. 18

Fig. 19

EP 0 312 498 B1

EP 0 312 498 B1

**Fig. 20**